(19) **Europäisches Patentamt**
**European Patent Office**
**Office européen des brevets**

(11) **EP 2 685 690 B1**

(12) **EUROPEAN PATENT SPECIFICATION**

(45) Date of publication and mention
of the grant of the patent:
**13.09.2017 Bulletin 2017/37**

(51) Int Cl.:
*H04L 27/26* (2006.01)     *H04L 27/34* (2006.01)
*H04L 27/36* (2006.01)     *H03C 5/00* (2006.01)
*H03F 1/32* (2006.01)

(21) Application number: **12005118.0**

(22) Date of filing: **11.07.2012**

(54) **Technique for generating a radio frequency signal based on an offset compensation signal**

Technik zur Erzeugung eines Funkfrequenzsignals auf der Basis eines Versatzkompensationssignals

Technique permettant de générer un signal de fréquence radio sur la base d'un signal de compensation de décalage

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**15.01.2014 Bulletin 2014/03**

(73) Proprietor: **Telefonaktiebolaget LM Ericsson
(publ)
164 83 Stockholm (SE)**

(72) Inventors:
• **Mu, Fenghao
24563 Hjärup (SE)**
• **Sundström, Lars
224 74 Lund (SE)**

(74) Representative: **Ericsson
Patent Development
Torshamnsgatan 21-23
164 80 Stockholm (SE)**

(56) References cited:
**US-A1- 2002 122 467     US-A1- 2008 002 788
US-A1- 2010 067 617     US-A1- 2011 116 535**

• **JINGCHENG ZHUANG ET AL: "A Technique to
Reduce Phase/Frequency Modulation Bandwidth
in a Polar RF Transmitter", IEEE TRANSACTIONS
ON CIRCUITS AND SYSTEMS I: REGULAR
PAPERS, IEEE, US, vol. 57, no. 8, 1 August 2010
(2010-08-01) , pages 2196-2207, XP011333746,
ISSN: 1549-8328, DOI:
10.1109/TCSI.2009.2037394**

## Description

## Technical Field

The present disclosure relates to a technique for generating a radio frequency signal. In particular, and without limitation, the disclosure relates to a transmitter chain of a mobile communication device and a method of operating such a transmitter chain.

## Background

Modern mobile communication techniques, such as Long Term Evolution (LTE), require the linearity of the transmitter chain, particularly the linearity of a power amplification, over a wide dynamic range for transmitting signals having a high Peak to Average Power Ratio (PAPR). Transmitted signals include, e.g., Orthogonal Frequency-Division Multiplexed (OFDM) signals and Single-Carrier Frequency-Division Multiple Access (SC-FDMA) signals, which are known to have a high PAPR. However, the power efficiency of a power amplifier operated in its linear mode is low due to the large headroom that always has to be provided to prevent the clipping of rare power peaks.

In order to improve the power efficiency compared to a linearly-operated power amplifier, a power amplifier can also be driven based on a polar modulation instead of a directly linear amplification of a modulated radio signal. The polar modulation requires an amplitude signal and a phase signal, each of which has a much wider bandwidth than the original modulation signal bandwidth. This is especially true for a signal path of the phase signal, the bandwidth of which is wider than the bandwidth of a signal path for the amplitude signal. Such a bandwidth expansion is caused by the non-linear map from "Cartesian" coordinates (corresponding to I and Q components provided in a quadrature-modulated signal) to polar coordinates (i.e., a signal representation including the phase signal). More precisely, bandwidth expansion in the phase signal for the polar coordinates is due to a discontinuity of the map at the constellation origin, i.e., at zero amplitude, because a small change in the Cartesian signal representation near the constellation origin is associated with a large change of the phase signal.

The output amplitude of such a polar-modulated power amplifier is controlled by a variable supply voltage, which is also referred to as supply modulation. A non-linear power amplifier or a switched power amplifier can be supply-modulated. The non-linear or switched power amplifier mainly operates in a saturated region or a cut-off region, so the product of current and voltage is small on an active device, thus reducing the power consumption and increasing the power efficiency. In the case of a switched power amplifier, the linear region is a transition between on-state and off-state of the switched power amplifier. The transition normally is only a small portion of a whole switching period, so that the average power consumption of the polar-modulated power amplifier is much lower compared to a linearly operated power amplifier providing the same dynamic range of output power. The document EP 1 492 228 A1 describes an amplifier system that generates an amplitude-modulated component and a phase-modulated component, which are provided to a non-linear type amplifier. However, the wide bandwidth of the phase signal, which is also referred to as bandwidth expansion, becomes a serious issue for modern radio telecommunication techniques, such as LTE, using a wide signal bandwidth.

In view of the poor power efficiency of a transmitter chain based on quadrature modulation on the one hand, and the detrimental bandwidth expansion of polar modulation on the other hand, an envelope tracking technique has been suggested. A DC-DC-converter provides a variable power supply to the power amplifier and the modulation does not follow quick changes in the amplitude but outputs the "envelope" of the signal to be amplified. A corresponding transmitter chain reduces the bandwidth expansion associated with the conversion of I and Q signals to the amplitude signal, but there always has to be voltage headroom to represent the quick changes in amplitude and to prevent the power amplifier from entering the non-linear region. Therefore, the power efficiency of the envelope tracking technique is also reduced compared to the polar-modulated power amplifier. The article "50% PAE W-CDMA Basestation Amplifier Implemented with GaN HFETs" by D. Kimball et al. describes such an envelope tracking amplifier for Wideband Code Division Multiple Access (W-CDMA).

J. Zhuang et al. describe in the research publication "A Technique to Reduce Phase/Frequency Modulation Bandwidth in a Polar RF Transmitter", IEEE Trans. on Circuits and Systems I, vol. 57, no. 8, pp. 2196 to 2207, a polar modulator, which modifies a signal trajectory such that it avoids crossing of the constellation origin. However, the resulting bandwidth reduction by adding an offset sequence before or after a Root-Raised-Cosine (RRC) filter in case of W-CDMA increases an Error Vector Magnitude (EVM) or an Adjacent Channel Leakage power Ratio (ACLR). The decrease in polar modulator bandwidth thus is only a trade-off against an increase of in-band modulation distortion and adjacent channel leakage. Furthermore, methods for reducing the PAPR, e.g., by clipping power peaks in the output signal, also suffer from distortions increasing EVM and ACLR.

Document US 2002/0122467 A1 describes a technique for reducing phase modulation bandwidth. A baseband processor provides synchronized amplitude and phase modulation signals. A phase reduction circuit generates a reduced bandwidth version of the phase modulation signal by reducing the magnitude of selected phase transitions. A signal source generates a phase modulated output signal at a desired carrier frequency based on the reduced bandwidth phase modulation signal. To restore lost phase transition information, a phase restoration circuit operates synchronously with the phase reduction circuit to substantially restore the full magnitude of those phase transitions. The restoration action generates a final phase modulated output signal, which drives a transmit amplifier circuit.

Document US 2010/0067617 A1 provides a technique for jumpless phase modulation. A phase of a baseband phase signal is selectively shifted upstream of a phase modulator. The impact of shifting the phase is compensated by means of an amplitude inverter before amplifying the phase signal according to a baseband amplitude signal.

Document US 2008/0002788 A1 describes means for handling exceptions when generating an RF signal for wideband wireless standards. An exception handler compares the frequency command information against a threshold.

Document US 2011/0116535 A1 describes a technique for reducing the ratio between an average magnitude of communication signals and a minimum magnitude of the communications signals. A magnitude of a local minimum of samples of the baseband signal is compared to various magnitude threshold levels. A modulator modulates a carrier signal based on a modified baseband signal. The modified signal is transmitted without compensation for the modification.

## Summary

Accordingly, there is a need for a technique that power-efficiently generates a radio frequency signal and fulfills specifications as to signal quality specified by radio standards.

According to a general aspect, a method of generating a radio frequency signal based on a baseband signal is provided. The method comprises the steps of providing an amplitude signal and a phase signal depending on the baseband signal; modulating the phase signal to a carrier frequency; amplifying the modulated phase signal according to the amplitude signal to generate a preliminary radio frequency signal; and feeding a compensation signal, which depends on the baseband signal, into the preliminary radio frequency signal to generate the radio frequency signal. The compensation signal may include at least one of an offset compensation signal and a peak compensation signal.

According to one aspect, a method of generating a radio frequency signal based on a baseband signal is provided. The method comprises the steps of modifying the baseband signal by adding an offset signal to the baseband signal, the offset signal being configured to prevent the modified baseband signal from entering a first signal region; providing an amplitude signal and a phase signal based on the modified baseband signal; modulating the phase signal to a carrier frequency and amplifying the modulated phase signal according to the amplitude signal to generate a preliminary radio frequency signal; and feeding an offset compensation signal derived from the offset signal into the preliminary radio frequency signal to generate the radio frequency signal, wherein the offset compensation signal is configured to at least essentially cancel a distortion component, which corresponds to the offset signal, in the preliminary radio frequency signal.

By modifying the baseband signal so that the modified baseband signal does not enter the first signal region, the provided phase signal and its subsequent processing does not necessarily suffer from a large bandwidth expansion. For example, the phase signal may change continuously or smoothly (e.g., avoiding sudden jumps for a time-continuous phase signal), or may change at increments of similar magnitude or at increments not exceeding a predefined maximum (e.g., for a time-discrete representation of the phase signal by means of a sequence of samples). By controlling the amplification of the phase signal according to the amplitude signal, it is not necessary to perform the amplification by operating a power amplifier, which is also referred to as a main power amplifier, in its linear regime. By feeding the offset compensation signal, e.g. via an auxiliary power amplifier, into the preliminary radio frequency signal, the signal quality of the resulting radio frequency signal may be comparable to a linearly operated power amplifier.

The modification may include generating the offset signal depending on the baseband signal to prevent the modified baseband signal from entering the first signal region. A single component may perform the steps of modulating and amplifying. The single component may be a polar-modulated power amplifier. Alternatively or in addition, the modulation may be performed by a modulator. The modulator may only receive the phase signal. The step of amplification may be performed by a power amplifier. The power amplifier may be supply-modulated. The amplitude signal may determine the supply modulation. The supply modulation may be determined so that the modulated phase signal is, at least in some signal regions, linearly amplified according to the amplitude signal.

The first signal region may be a prohibited signal region or an excluded signal region. The modified baseband signal may never enter the first signal region as a result of the added offset signal. The first signal region may be a vicinity of the origin in a plane spanned by the I component and the Q component, an area of a circle or ellipse centered at a constellation origin, or any other domain of the constellation plane of the baseband signal, wherein the domain includes a discontinuity of a baseband signal processing. Alternatively, the first signal region may be a rectangle including the origin. A minimum amplitude may define an upper limit of the first signal region. The minimum amplitude may be determined by at least one of a maximum bandwidth of a phase signal path and maximum bandwidth of an amplitude signal path.

If the baseband signal is in a second signal region, the modification step may be performed and the offset compensation signal may be derived from the offset signal. At least one of modifying the baseband signal, feeding the offset compensation signal into the radio frequency signal, and deriving the offset compensation signal from the offset signal may be performed, only if the baseband signal is in the second signal region. E.g., the step of modifying the baseband signal by the offset signal and feeding the offset compensation signal may be performed, only if the baseband signal is in the second signal region.

The second signal region may completely include the first signal region. The first signal region may be a subset of the second signal region. An activation amplitude may define an upper limit of the second signal region. A value of the activation amplitude may be adaptive to the maximum output power level. The minimum amplitude may be smaller than the activation amplitude. An amplitude of the offset signal may depend on an amplitude of the baseband signal. The offset signal may vanish as the amplitude of the baseband signal is close to or equal to the activation amplitude. The offset signal may be computed based on or equal to a product. The product may include a scalar factor and a vectorial factor. The scalar factor may be a monotonically decreasing function of the amplitude of the baseband signal. The scalar factor may smoothly vanish at the activation amplitude. A first, a second, or all derivatives of the scalar factor may vanish at the activation amplitude. E.g., the scalar factor may be proportional to $\exp(-1/(r-r_{min})^2)$ within the second signal region and zero outside the second signal region, wherein r denotes the amplitude of the baseband signal and $r_{min}$ denotes the activation amplitude. The vectorial factor may define a direction of the modification in constellation space. At least for some trajectories of the baseband signal, the vectorial factor may be independent of the amplitude of the baseband signal.

At least one of the first signal region and the second signal region may change depending on a modulation scheme applied for the baseband signal. For example, the minimum amplitude and/or the activation amplitude may be a function of the modulation scheme. Alternatively or in addition, the minimum amplitude and/or the activation amplitude may be scaled depending on the maximum output power level of the radio frequency signal to be transmitted. The modulation schemes may include QPSK (Quadrature Phase-Shift Keying) or QAM (Quadrature Amplitude Modulation), OFDM and SC-OFDM.

At least one of the modulation and the amplification may be performed by operating a component in a non-linear mode or in a switch mode. For example, the modulator and/or the power amplifier may be operated in the non-linear mode or in the switched mode.

The amplitude signal may depend on the baseband signal such that the radio frequency signal is at least essentially a linear frequency translation of the baseband signal. The amplitude signal may control the supply modulation of the power amplifier. The amplitude signal may be a supply voltage or may determine a supply voltage. The amplitude signal or the supply voltage may account for a non-linear characteristic or a supply response of the power amplifier, e.g. by pre-distorting means.

If the baseband signal is in a third signal region, at least essentially no offset signal is added. The third signal region may be adjacent to the second signal region. The third signal region may be outside the second signal region. The third signal region may surround the second signal region. The first signal region, the second signal region and/or the third signal region may include a region of linear frequency translation of the baseband signal or effective linear dependency of the output signal level of the radio frequency signal on the amplitude of the baseband signal.

The method may further comprise feeding a peak compensation signal into the radio frequency signal. The peak compensation signal may be derived from the baseband signal. The peak compensation signal may at least essentially compensate for a saturation in the amplification step. The peak compensation signal may be fed or coupled into the preliminary radio frequency signal.

The peak compensation signal may be derived and/or fed, only if the baseband signal is in a fourth signal region. The fourth signal region may be adjacent to the third signal region. The fourth signal region may surround the third signal region in constellation space.

A saturation amplitude may define at least one of an upper limit of the third signal region and a lower limit of the fourth signal region. The third signal region may be defined by an amplitude of the baseband signal being between the activation amplitude and the saturation amplitude. The saturation amplitude may indicate a beginning of a saturation in the supply modulation response used in the amplification. The saturation amplitude may be a saturation amplitude of the supply-modulated power amplifier. The saturation amplitude may be defined as the amplitude of the baseband signal, at which the preliminary radio frequency signal at least essentially reaches a maximum output signal level that cannot be effectively increased by means of the supply modulation.

An amplitude of the peak compensation signal may be a function of the amplitude of the baseband signal. The peak compensation signal and the preliminary radio frequency signal may be equal in phase. The peak compensation signal level may have the same order as the preliminary radio frequency signal. The peak compensation signal may enhance the preliminary radio frequency signal. The peak compensation signal may at least essentially compensate for a saturation of the supply-modulated power amplifier.

The peak compensation signal may increase linearly as a function of the baseband signal, if the baseband

4

signal is in a fifth signal region. The fifth signal region may correspond to an at least essentially complete saturation of the power amplifier. A clipping amplitude may define a lower limit of the fifth signal region. The clipping amplitude may correspond to a baseband amplitude or the maximum output power level in the power amplifier, at which the power amplifier clips the baseband amplitude. The output signal level of the preliminary radio frequency signal may be essentially constant in the fifth signal region.

Any two or all of the second signal region, the third signal region, the fourth signal region, and the fifth signal region may be mutually exclusive or disjoint domains of constellation space.

The offset compensation signal and the peak compensation signal may be generated by means of the auxiliary power amplifier and/or derived by a feeding unit comprising the auxiliary power amplifier. The same feeding unit and/or the same auxiliary power amplifier may be used to either generate the offset compensation signal or the peak compensation signal. The offset compensation signal and the peak compensation signal may be collectively referred to as a compensation signal. An output of the auxiliary power amplifier may be referred to as the compensation signal (e.g., independent of the signal region traversed by the baseband signal). The compensation signal may be fed into the radio frequency signal by means of a coupling unit (e.g., in the voltage domain or in the current domain). The auxiliary power amplifier or the feeding unit may be deactivated or currentless, if the baseband signal is in the third signal region.

The method may further include the steps of generating a calibration signal, from which the compensation signal is derived according to the alignment setting; detecting a component, which corresponds to the calibration signal, in a radio frequency signal path downstream of the feeding of the compensation signal; and calibrating the alignment of the compensation signal. The calibration may aim at reducing the detected component. The calibration signal may substitute a least one of the baseband signal and the offset signal. The calibrating may change one or more of the time delay, the phase rotation and the gain adjustment. The calibration may maximize a compensation effect of the offset compensation signal. The calibration signal may be generated at an intermediate frequency outside frequency bands used for a transmission of the baseband signal.

According to another aspect, a method of generating a radio frequency signal based on a baseband signal is provided. The method comprises the steps of providing an amplitude signal and a phase signal depending on the baseband signal; modulating the phase signal to a carrier frequency and amplifying the modulated phase signal according to the amplitude signal to generate a preliminary radio frequency signal; and feeding a peak compensation signal, which depends on the baseband signal, into the preliminary radio frequency signal to generate the radio frequency signal, wherein the peak compensation signal at least essentially compensates for a saturation in the amplification step.

The method may be combined with any method steps according to other method aspects disclosed herein. E.g., the peak compensation signal may be fed into the preliminary radio frequency signal, only if the baseband signal is in the fourth signal region or the fifth signal region.

According to a further aspect, a computer program product is provided, which comprises program code portions for performing the steps of any one of the methods and method aspects described herein, when the computer program product is executed on one or more computing devices, for example on a mobile communication device, on a network, or on a data card. The computer program product may be stored on a computer-readable recording medium, such as permanent or re-writable memory within or associated with the computing devices. The computer program product may also be provided for download to the computing device, for example via a data network such as the Internet and/or a communication connection such as a wireless link.

According to a still further aspect, a device for generating a radio frequency signal based on a baseband signal is provided. The device comprises a modifying unit adapted to modify the baseband signal by adding an offset signal to the baseband signal, the offset signal being configured to prevent the modified baseband signal from entering a first signal region; a providing unit adapted to provide an amplitude signal and a phase signal based on the modified baseband signal; a modulating and amplifying unit adapted to modulate the phase signal to a carrier frequency and to amplify the modulated phase signal according to the amplitude signal to generate a preliminary radio frequency signal; and a feeding unit adapted to feed an offset compensation signal derived from the offset signal into the preliminary radio frequency signal to generate the radio frequency signal, wherein the offset compensation signal is configured to at least essentially cancel a distortion component, which corresponds to the offset signal, in the preliminary radio frequency signal.

The device may further include features described above in relation to any one of the method aspects, or units adapted to perform one or more steps of such method aspects. E.g., the feeding unit may include an alignment unit. The alignment unit may include one or more of a delay unit, a phase rotation unit and a gain adjustment unit. A calibrating unit may be adapted to calibrate one or more of the delay unit, the phase rotation unit and the gain adjustment unit.

**Brief Description of the Drawings**

In the following, the present disclosure is described in more detail with reference to exemplary embodiments illustrated in the drawings, in which:

Fig. 1     shows a baseband signal as a function of time in the plots (a) to (c) and in constellation space in the plot (d).

Fig. 2     shows four plots of a waveform of the baseband signal that causes a bandwidth expansion in a phase signal path;

Fig. 3     shows a schematic high-level block diagram of a device for generating a radio frequency signal based on a baseband signal according to the present invention;

Fig. 4     shows a flow diagram of a method of generating a radio frequency signal based on a baseband signal that can be performed by the device of Fig. 3;

Fig. 5     illustrates three trajectories of the baseband signal and a modified baseband signal in constellation space for small amplitudes;

Fig. 6     illustrates a construction of a vectorial factor defining a direction in constellation space for an offset signal;

Fig. 7     illustrates a plot of a complementary cumulative probability distribution of peak power;

Fig. 8     illustrates a trajectory of the baseband signal and the modified base-band signal in constellation space for large amplitudes;

Fig. 9     illustrates signal power levels of a preliminary radio frequency signal, a compensation signal, and a radio frequency signal for small and large amplitudes;

Fig. 10    shows a more detailed schematic block diagram of a first embodiment of the device of Fig. 3;

Fig. 11    shows a more detailed schematic block diagram of a second embodiment of the device of Fig. 3;

Fig. 12    shows a schematic block diagram of a switched polar-modulated auxiliary power amplifier that can be used in the first embodiment of Fig. 10; and

Fig. 13    shows a more detailed schematic block diagram of a variant of the first embodiment of the device of Fig. 11 for calibrating an alignment setting.

**Detailed Description**

In the following description, for purposes of explanation and not limitation, specific details are set forth to provide a thorough understanding of the present disclosure. It will be apparent to those skilled in the art that the technique disclosed herein may be practiced in other embodiments that depart from these specific details. For example, while the following embodiments will primarily be described for OFDM signals or SC-FDMA signals as a baseband signal, the skilled artisan will appreciate that the present disclosure is not limited to an LTE implementation. Moreover, while the embodiments focus on a transmitter implementation in a mobile communication device, it will be apparent that the technique can also be implemented in a base station.

Those skilled in the art will further appreciate that the functions explained herein may be implemented using individual hardware components, using software functioning in conjunction with a programmed microprocessor or general purpose computer, using an Application Specific Integrated Circuit (ASIC), or using one or more Digital Signal Processes (DSPs). It will also be appreciated that the technique described herein could be embodied in a processor and a memory coupled to the processor, wherein the memory is encoded with one or more programs that perform the methods or method aspects disclosed herein when executed by the processor.

A pair of an in-phase component and a quadrature-phase component is also referred to as a quadrature-modulated signal. A pair of a phase signal with constant amplitude and an amplitude signal is also referred to as a polar-modulated signal.

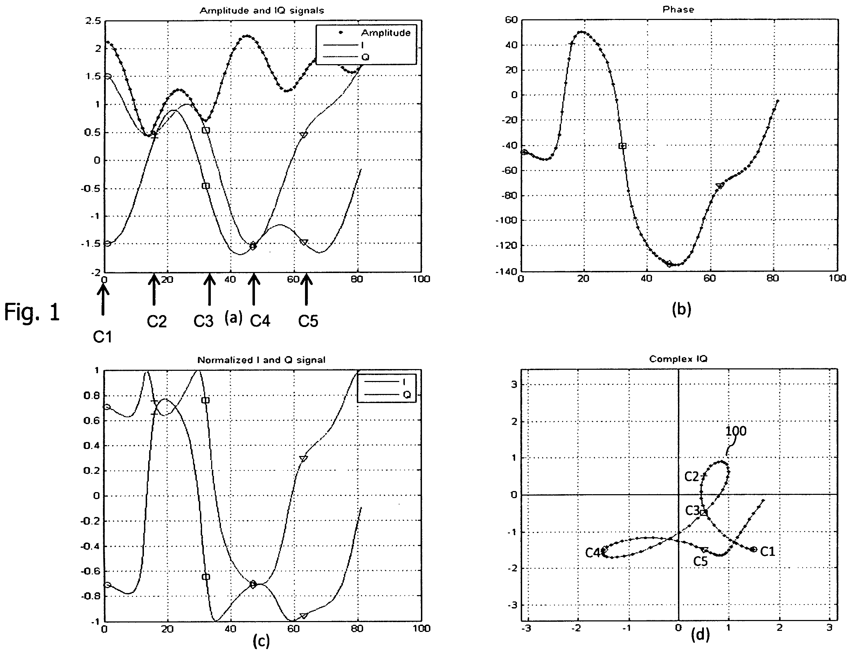

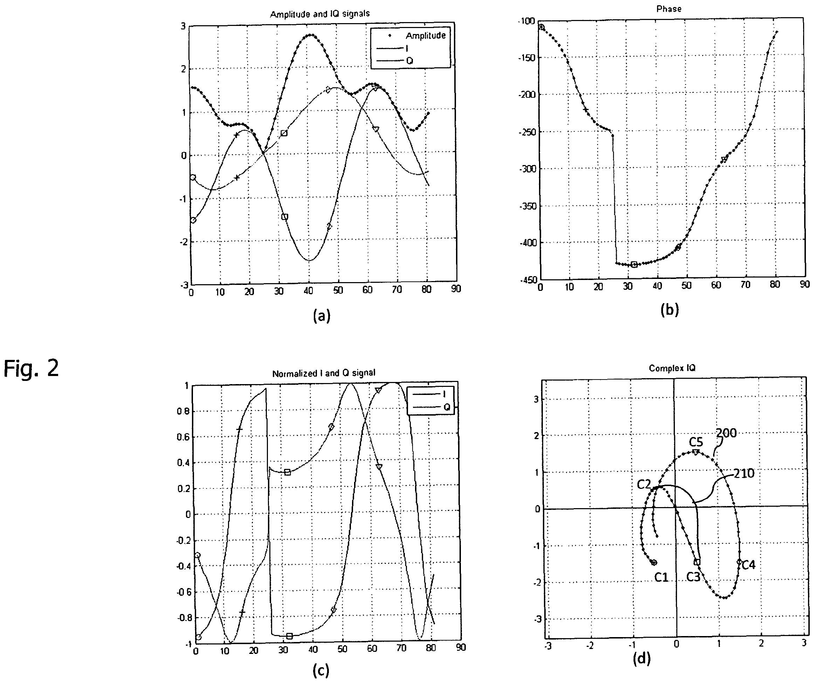

Each of the Figs. 1 and 2 shows a sequence of five symbols that are representative of a symbol sequence of OFDM signals or SC-FDMA signals used in an uplink channel of a mobile communication device according to Long Term Evolution (LTE). In terms of bandwidth expansion, Fig. 1 shows a "good" sample and Fig. 2 shows a "bad" sample. The five symbols are denoted by C1 to C5 and correspond to a sample of LTE SC-FDMA using 16QAM. Each of the Figs. 1(a) and 2(a) shows a diagram including the graphs of an I component, a Q component, and an amplitude signal r as a function of time t. Each of the Figs. 1(b) and 2(b) shows a graph of a phase signal $\varphi$ as a function of time corresponding to the I and Q components shown in Figs. 1(a) and 1(b), respectively. Normalized graphs of the I and Q components are shown in the Figs. 1(c) and 2(c). The I and Q components define a quadrature-modulated baseband signal. The quadrature-modulated baseband signal, as represented by I(t) and Q(t), can be converted into a polar-modulated signal R(t) including the amplitude signal r(t) and the phase signal φ(t) according to

$$r(t) = \sqrt{I^2(t) + Q^2(t)}$$
$$\varphi(t) = \arctan(\frac{Q(t)}{I(t)})$$
$$R(t) = r(t)e^{j\varphi(t)} \qquad . \qquad\qquad (1)$$

The Figs. 1(d) and 2(d) show a trajectory of the five symbols in the complex constellation plane according to I(t) + j · Q(t) = R(t).

While the trajectory shown in Fig. 1(d) is located sufficiently away from the origin of the constellation plane corresponding to a continuous change in the phase signal φ(t) shown in Fig. 1(b), the trajectory shown in Fig. 2(d) essentially passes through the origin (i.e., comes very close to the origin compared to the extent of the trajectory in the constellation plane), which causes a sudden phase jump between the symbols C2 and C3. The phase jump essentially corresponds to 180°. Such a discontinuous behavior of the phase signal φ(t) causes a significant bandwidth expansion. The bandwidth expansion would be avoided, if the trajectory was pushed away from the origin, as is indicated by a segment 210 resulting by adding an offset sequence to the trajectory 200.

However, adding such an offset sequence reduces the signal quality of a radio frequency signal output by a transmitter in terms of an increased Error Vector Magnitude (EVM) and/or an increased Adjacent Channel Leakage Ratio (ACLR).

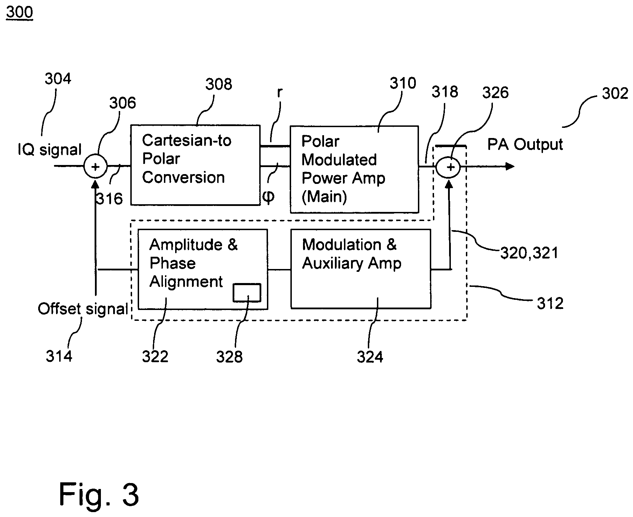

Fig. 3 shows a block diagram schematically illustrating a device 300 for generating a radio frequency signal 302 based on a baseband signal 304. The device 300 comprises a modifying unit 306, a providing unit 308, a modulating and amplifying unit 310, and a feeding unit 312. The baseband signal 304 may be an IQ signal.

The modifying unit 306 is adapted to modify the baseband signal 304 by adding an offset signal 314 to the baseband signal 304 resulting in a modified baseband signal 316. The offset signal 314 is configured to prevent the modified baseband signal 316 from entering a first signal region. The providing unit 308 is adapted to provide an amplitude signal r and a phase signal φ converted from the modified baseband signal 316. The modulating and amplifying unit 310 is adapted to modulate the phase signal φ to a carrier frequency $\omega_c$ and to amplify the modulated phase signal according to the amplitude signal r to generate a preliminary radio frequency signal 318.

The feeding unit 312 is adapted to feed an offset compensation signal 320 into the preliminary radio frequency signal 318 to generate the radio frequency signal 302. The offset compensation signal 320 is derived from the offset signal 314. The offset compensation signal 320 is configured to at least essentially cancel a distortion component, which corresponds to the offset signal 314, in the preliminary radio frequency signal 318. The modifying unit 306 is also referred to as a first adder 306.

At least one of the baseband signal 304, the offset signal 314, the modified baseband signal, the amplitude signal, the phase signal, and any other disclosed signal may be represented by a sequence of samples. At least one of the baseband signal 304, the offset signal 314, the modified baseband signal and the phase signal may be represented by a pair of an in-phase component (I component) and a quadrature-phase component (Q component). The phase signal may be represented by a pair of an I component and a Q component that have a constant amplitude, e.g., according to $I^2+Q^2$=constant. In other words, the phase signal may be represented by a rotating vector having a pair of orthogonal components I and Q. For a radio frequency phase signal, the vector rotates at the carrier frequency.

The feeding unit 312 includes an alignment unit 322, an auxiliary modulating and amplifying unit 324 and a second adder 326. The second adder 326 may be implemented by a coupler, a combination transformer, passive networks, or similar means. For example, the feeding may be performed directly in the voltage domain or in the current domain. The feeding in the current domain may include applying the preliminary radio frequency signal and the offset compensation signal to the same node. A maximum output power fed into the preliminary radio frequency signal may only be determined by a maximum magnitude of the offset signal. The maximum output power fed into the preliminary radio frequency signal may be 15-25 dB lower than a maximum output power of the preliminary radio frequency signal based on the baseband signal. As a relatively low maximum output power level is required from the auxiliary amplifier (being, e.g., 15-25 dB lower than the maximum output power of the main power amplifier), the feeding in the current domain can be linear and the distortions introduced by the offset signal can be compensated.

The alignment unit 322 and the auxiliary modulating and amplifying unit 324 are adapted for the step of deriving of the offset compensation signal 320 from the offset signal 314. The alignment unit 322 receives the offset signal 314.

The alignment unit 322 aligns an amplitude of the offset signal 314 and a phase of the offset signal 314 according to an alignment setting 328 stored in the alignment unit 322. The offset compensation signal 320 is thus aligned according to the alignment setting 328 relative to the preliminary radio frequency signal 318. The alignment setting 328 is configured so that an amplitude of the offset compensation signal 320 is essentially equal to an amplitude of the distortion component and a phase of the offset compensation signal 320 is opposite to a phase of the distortion component.

The auxiliary modulating and amplifying unit 324 includes a quadrature-modulated power amplifier according to a first embodiment or a phase modulator in conjunction with a supply-modulated power amplifier according to a second embodiment. The offset compensation signal 320 thus is a modulated version of the offset signal 314.

By adding the offset signal 314 to the baseband signal 304, the corresponding symbol trajectory 200 is modified and pushed away from the constellation origin according to the segment 210 shown in Fig. 2. As a result, the modified baseband signal 316 does not exhibit the bandwidth expansion and the providing unit 308 provides the phase signal at a limited bandwidth. By feeding the offset compensation signal 320 into the preliminary radio frequency signal 318, an influence of the offset signal 314 on the spectrum and the EVM is removed from the radio frequency signal 302.

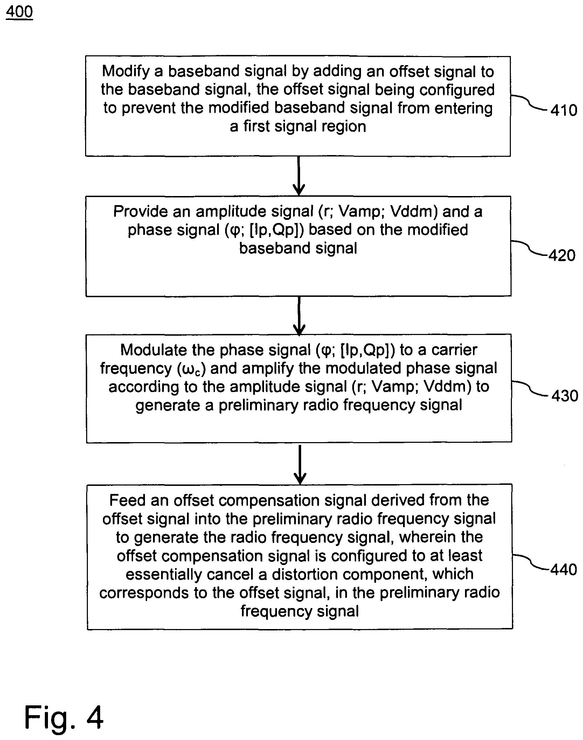

Fig. 4 shows a flow chart of a method 400 of generating a radio frequency signal based on a baseband signal. The method 400 may be performed by the device 300. The radio frequency signal may correspond to the radio frequency signal 302 and the baseband signal may correspond to the baseband signal 304 described above with reference to Fig. 3.

The method 400 comprises a step 410 of modifying the baseband signal, a step 420 of providing an amplitude signal r and a phase signal φ based on the modified baseband signal, a step 430 of modulating the phase signal φ to a carrier frequency $\omega_c$ and amplifying the modulated phase signal according to the amplitude signal r to generate a preliminary radio frequency signal 318, and a step 440 of feeding an offset compensation signal 320 into the preliminary radio frequency signal 318. The offset signal 314 is configured to prevent the modified baseband signal 316 from entering a first signal region. The offset compensation signal 320 is derived from the offset signal 314. The offset compensation signal 320 is configured to at least essentially cancel a distortion component corresponding to the offset signal 314 in the preliminary radio frequency signal 318.

The steps 410, 420, 430 and 440 may be performed by the units 306, 308, 310 and 312, respectively. The method may further comprise, prior to the step 410, a step of predicting the signal amplitude. Latter step is possible, since the signal is known at the transmitter. The method may further comprise a step of assessing, based on the amplitude, whether the trajectory would enter the first signal region, or not.

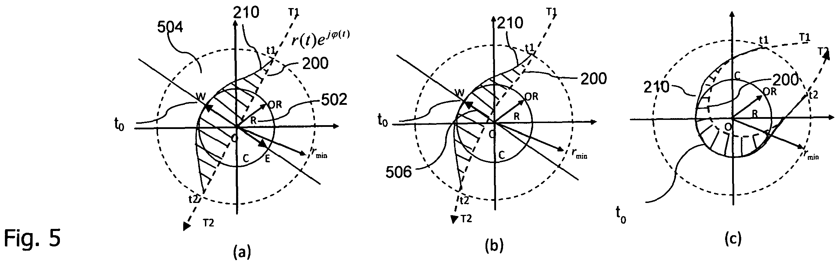

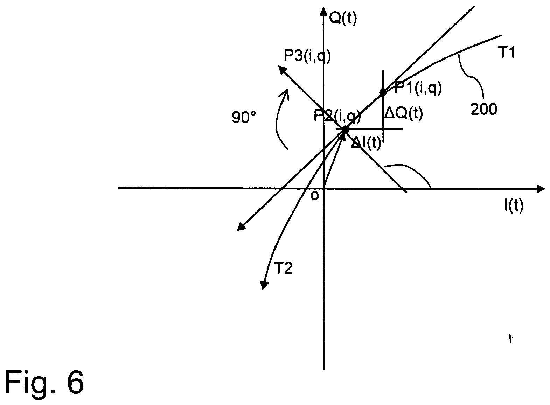

The step 410 of modifying the baseband signal 304 is illustrated in more detail in Figs. 5 and 6 in the constellation space spanned by the I and Q components, as introduced above with reference to Figs. 1(d) and 2(d). Using the complex-valued representation R(t) of the amplitude signal r(t) and the phase signal φ(t) defined by above set of equations (1), the polar-modulated signal R(t) is split in three different signal regions:

$$R(t) = r(t)e^{j\varphi(t)}$$

$$= \begin{cases} Ro(t)e^{j\theta(t)} - ro(t)e^{j\theta o(t)}, & r(t) < r_{min} \\ r(t)e^{j\varphi(t)}, & r_{min} \leq r(t) \leq r_{max} \\ r_{max}e^{j\varphi(t)} + \left[r(t) - r_{max}\right]e^{j\varphi(t)}, & r_{max} < r(t) \end{cases} \tag{2}$$

wherein

$$Ro(t)e^{j\theta(t)} = r(t)e^{j\varphi(t)} + ro(t)e^{j\varphi o(t)}, \quad r(t) < r_{min} \tag{3}$$

is the modified baseband signal 316 represented as a polar-modulated signal and defined inside a circle of radius $r_{min}$ centered at the constellation origin. The offset signal 314 is represented as a polar-modulated signal by the second term on the right-hand side of equation (3). By inserting the offset signal 314 into the baseband signal 304, the polar components of the resulting modified baseband signal 316 according to equation (3) have a significantly reduced bandwidth compared to the polar components of the original baseband signal 304 according to equation (2).

The embodiment of the device 300 described above with reference to Fig. 3 performs the insertion of the offset signal 314 in "Cartesian coordinates", i.e., prior to converting the quadrature-modulated baseband signal 304 to a polar-modulated signal by means of the providing unit 308.

An exemplary generation of the offset signal 314, which is compatible with all device embodiments and method embodiments described herein, is illustrated with reference to the Figs. 5 and 6 using an implementation in polar coordinates. An offset sequence of the offset signal 314 is generated, wherein the amplitude ro(t) of the offset signal 314 is

computed according to:

$$\varphi_o(t) = \varphi(t) \pm \frac{\pi}{2}, \qquad t1 < t < t2$$

$$ro(t) = Ao \cdot e^{\frac{-(t-t0)^2}{2\sigma t^2}} = \max(R - r(t)) \cdot e^{\frac{-(t-t0)^2}{2\sigma t^2}}, \qquad (4)$$

wherein Ao is a maximum amplitude of the offset signal 314 required to keep the modified baseband signal 316 according to equation (3) outside a first region 502 defined by a circle centered at the constellation origin with radius R, as is shown in Fig. 5. The circle with the radius $r_{min}$ defines a second signal region 504 that completely includes the first signal region 502.

In an alternative implementation using Cartesian coordinates, an in-phase component Io(t) and a quadrature-phase component Qo(t) are computed according to:

$$ro(t) = Ao \cdot e^{-\frac{(t-t0)^2}{2\sigma_t^2}}$$

$$Ao = \max(R - \sqrt{I^2(t) + Q^2(t)})$$

$$\varphi_o(t) \equiv \arctan\left(\frac{Qo(t)}{Io(t)}\right) \approx \arctan\left(-\frac{\Delta I(t)}{\Delta Q(t)}\right)$$

$$Io(t) = ro(t)\sin(\varphi_o(t))$$

$$Qo(t) = ro(t)\cos(\varphi_o(t)) \qquad . \qquad (4b)$$

The points labeled by time stamps t1 and t2 on the trajectory indicate where the trajectory 200 enters and leaves the second signal region 504, respectively, as is shown in Fig. 5. The maximum amplitude of the offset signal 314 occurs at a time t0, which is approximately at (t1+t2)/2. Fig. 5(a) shows the case of a trajectory of the baseband signal 304 that essentially passes over the constellation origin. In this case, the offset signal 314 can be inserted in two ways that force the trajectory of the modified baseband signal 316 to pass either point E or W on the circle C defining the boundary of the first signal region 502.

In the general case shown in Fig. 5(b), the original baseband signal 304 passes by the constellation origin but traverses through the first signal region 502. In this case, a vectorial factor 506 defining the direction of the offset signal 314 in constellation space is almost constant in time with a small direction variation. The side at which the original baseband signal 304 passes by the constellation origin thus defines the vectorial factor 506 of the offset signal 304. In one variant, the constant direction OW (i.e., the vector pointing from the constellation origin to the point W) is used for computing the offset sequence of the offset signal 314.

The computation of the vectorial factor 506 defining the direction of the offset signal 314 in constellation space is illustrated in Fig. 6. The original baseband signal 304 corresponds to a trajectory, a segment of which is shown from T1 to T2. The segment T1T2 includes sample points P1(i,q) and P2(i,q). To calculate the vectorial factor P2P3 of the offset signal 314 at the sample point P2, the vectorial difference between P1 and P2 is calculated in the plane spanned by the components I and Q. The vectorial difference $[\Delta I(t), \Delta Q(t)] = [P1(i,q) - P2(i,q)]$ is a tangential direction of the trajectory segment at the sample point P2. The direction P2P3 defining the vectorial factor for the computation of the offset signal 314 at the point P2 is perpendicular to P1P2. It is noted that the vectorial factor can be computed, for example, by applying a matrix

$$\begin{bmatrix} 0, & -1 \\ 1, & 0 \end{bmatrix},$$

without deriving or processing the (potentially bandwidth-expanded) phase φ of the baseband signal 304.

Above examples for generating the offset signal 314 also apply to the situation shown in Fig. 5(c), in which the trajectory 200 corresponding to the original baseband signal 304 forms a turn inside the first signal region 502 and is pushed outside of the first signal region 502 according to the segment 210.

While the operation of the device 300 according to the method 400 is described above with emphasis on the first signal region 502 and the second signal region 504 for small amplitudes, the same hardware, in particular the auxiliary modulating and amplifying unit 324 and the second adder 326 of the feeding unit 312, can be re-used for large amplitudes of the baseband signal 304. More specifically, large amplitudes refer to amplitudes of the baseband signal 304 that exceed a saturation amplitude $r_s$ of the modulating and amplifying unit 310.

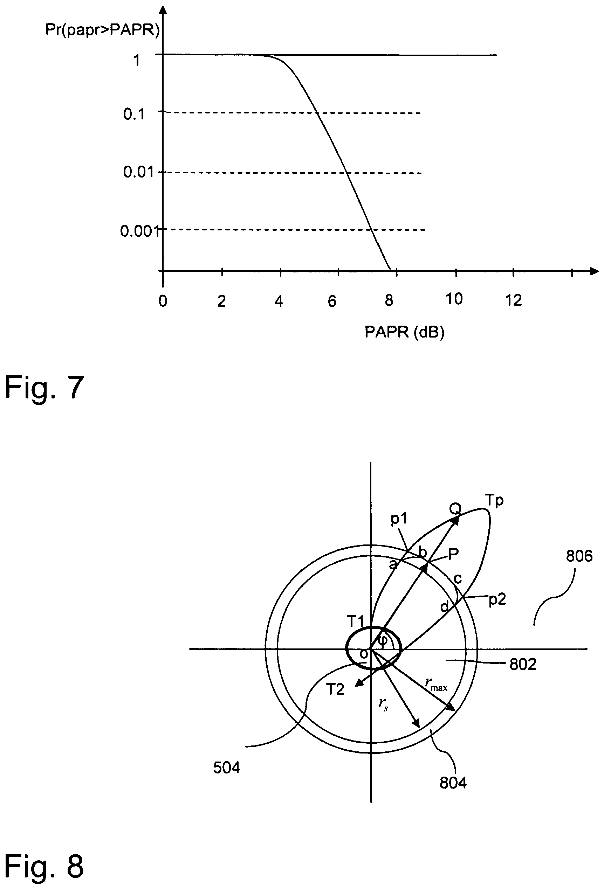

Fig. 7 shows a cumulative amplitude distribution plot of a typical complex-valued baseband signal 304 including OFDM or SC-FDMA symbols. The vertical logarithmic axis of the diagram shown in Fig. 7 represents the probability for a current peak to average power ratio (which is shown on the horizontal axis) being below the total peak to average power ratio of the baseband signal 304. The exponential decay of the probability indicates the rareness of such large peaks. Due to the limited output signal power level of the modulating and amplifying unit 310, the radio frequency signal 302 may suffer from an amplitude clipping. For SC-FDMA or OFDM used in an uplink of a mobile device according to LTE, the amplitude clip causes a distortion of the radio frequency signal 302 increasing the EVM and the ACLR. In other words, the signal quality of a conventional transmitter chain is also degraded for large amplitudes, and it is suggested to re-use the same auxiliary modulating and amplifying unit 324 and the same second adder 326 in the large-amplitude regions, as is described below.

Amplitudes of the baseband signal larger than the activation amplitude $r_{min}$ (which defines the upper limit of the second signal region 504) and smaller than the saturation amplitude $r_s$ define a third region 802 shown in Fig. 8. The second signal region 504 is either dynamically or statically scaled to the signal power level of the output radio frequency signal 302. As the saturation amplitude $r_s$ is determined by a transfer function of the power amplifier 310, the saturation amplitude $r_s$ is normally a fixed parameter, while $r_{min}$ is a scalable parameter. For amplitudes above the activation amplitude $r_{min}$, i.e., outside the second signal region 504, no offset signal 314 is generated and the alignment unit 322 is deactivated. The auxiliary modulating and amplifying unit 324 is only deactivated in the third signal region 802.

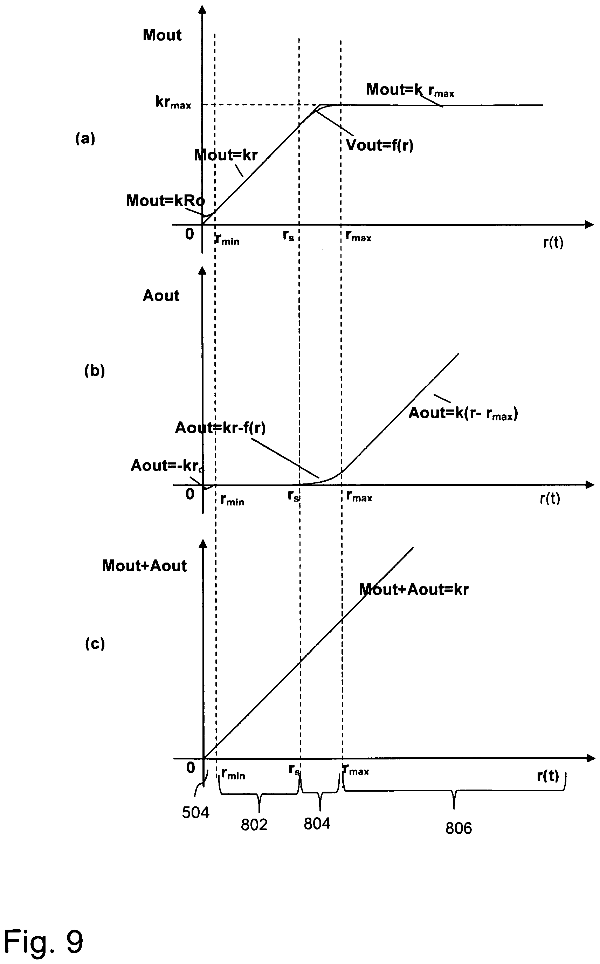

To enhance the output signal power level of the modulating and amplifying unit 310, the auxiliary modulating and amplifying unit 324 is enabled or switched on, if the amplitude of the baseband signal 304 exceeds the saturation amplitude $r_s$. Fig. 9(a) illustrates the output signal amplitude, Mout, of the preliminary radio signal 318 that is output by the modulating and amplifying unit 310. Above a clipping amplitude $r_{max}$ of the baseband signal 304, the output signal amplitude Mout of the modulating and amplifying unit 310 is essentially constant. The transition region for amplitudes larger than the saturation amplitude $r_s$ and smaller than the clipping amplitude $r_{max}$ is referred to as a fourth signal region 804, as is shown in each of the Figs. 8 and 9. Baseband signals 304 having an amplitude above the clipping amplitude $r_{max}$ are collectively referred to as a fifth signal region 806, which is also shown in the Figs. 8 and 9.

The auxiliary modulating and amplifying unit 324 thus provides a peak compensation signal 321 in the fourth signal region 804 and the fifth signal region 806. The phase signal may be applied to the auxiliary power amplifier in at least one of the fourth signal region 804 and the fifth signal region 806. The auxiliary power amplifier may be a polar-modulated auxiliary power amplifier or a quadrature-modulated auxiliary power amplifier. The auxiliary power amplifier may be operative in a linear mode, e.g., in the fourth signal region 804.

The compensation signal 320 or 321 may be aligned relative to at least one of the baseband signal 304 and the offset signal 314. The compensation signal 320 or 321 may be aligned according to an alignment setting. The alignment may include one or more of time delaying, phase rotating and gain adjusting the compensation signal. The alignment setting may be stored and/or updated.

Fig. 9(b) illustrates an output power of the peak compensation signal 321 in the fourth signal region 804 and in the fifth signal region 806. The peak compensation signal 321 is fed into the preliminary radio frequency signal 318 by means of the second adder 326. The additional output power Aout provided by the auxiliary modulating and amplifying unit 324 to the modulating and amplifying unit 310 thus reduces the probability of amplitude clipping. Fig. 9(c) illustrates the output signal power of the radio frequency signal 302 downstream of the second adder 326. Denoting the gain of the modulating and amplifying unit 310 (in the third signal region 802) by the symbol k, the combined output power of the radio frequency signal 302 from both the modulating and amplifying unit 310 and the auxiliary modulating and amplifying unit 324 is a linear function of the amplitude signal r of the baseband signal 304 with the gain k maintained in the fourth signal region 804 and in the fifth signal region 806.

Fig. 9 also provides an overview including the second signal region 504 and the third signal region 802 described above with reference to the equations (2) to (4b). A negative value of Aout shown in Fig. 9(b) for the second signal region 504 corresponds to the offset compensation signal 320, which phase is aligned by means of the alignment unit 322 to counter the phase of the preliminary radio frequency signal 318, which output signal amplitude, Mout, is shown in Fig. 9(a).

The offset compensation signal 320 and the peak compensation signal 321 are collectively referred to as compensation signals 320, 321. It is emphasized that, while a polar-modulated notation is used in what follows for the compensation signals 320, 321, the auxiliary modulating and amplifying unit 324 providing the compensation signals 320, 321 can be implemented either in polar modulation or quadrature modulation domain.

The compensation signals 320, 321 are described with reference to the Figs. 5, 8 and 9 for a polar-modulated implementation of the modulating and amplifying unit 310. The preliminary radio frequency signal 318 is optimized in the first signal region 502 and the second signal region 504 by feeding the offset compensation signal 320 into the preliminary radio frequency signal 318, and the maximum output level $k \cdot r_{max}$ is enhanced in the fourth signal region

804 and the fifth signal region 806 by feeding the peak compensation signal 321 into the preliminary radio frequency 318. The preliminary radio frequency signal that is output by the modulating and amplifying unit 310 is denoted by the symbol Mout and expressed as:

$$Mout(t) = \mathrm{Re}\left[M(t)e^{-j\left[\omega t + \zeta(t) + \sigma(t)\right]}\right]$$

$$M(t)e^{-j\left[\omega t + \zeta(t) + \sigma(t)\right]} = \begin{cases} k \cdot Ro(t)e^{-j\left[\omega t + \theta(t) + \sigma(t)\right]}, & r(t) < r_{min} \\ k \cdot r(t)e^{-j\left[\omega t + \varphi(t) + \sigma(t)\right]}, & r_{min} < r(t) < r_s \\ f(r(t))e^{-j\left[\omega t + \varphi(t) + \sigma(t)\right]}, & r_s < r(t) < r_{max} \\ k \cdot r_{max}e^{-j\left[\omega t + \varphi(t) + \sigma(t)\right]}, & r_{max} < r(t) \end{cases}$$

and

$$\zeta(t) = \begin{cases} \theta(t), & r(t) < r_{min} \\ \varphi(t), & r(t) \geq r_{min} \end{cases} \qquad . \ (5)$$

Using a corresponding complex notation, the compensation signals 320, 321 that are output by the auxiliary modulating and amplifying unit 324 are denoted by the symbol Aout and expressed as:

$$Aout(t) = \mathrm{Re}\left[A(t)e^{-j\left[\omega t + \psi(t) + \sigma(t)\right]}\right]$$

and the modulation phase

$$\psi(t) = \begin{cases} \varphi_o(t), & r(t) < r_{min} \\ \varphi(t), & r(t) \geq r_{min} \end{cases}$$

and the modulation amplitude

$$A(t) = \begin{cases} -k \cdot ro(t), & r(t) < r_{min} \\ o(t), & r_{min} < r(t) < r_s \\ \left[k \cdot r(t) - f(r(t))\right] & r_s < r(t) < r_{max} \\ k \cdot (r(t) - r_{max}), & r_{max} < r(t) \end{cases} \qquad . \qquad (6)$$

The contribution, o(t), of the auxiliary modulating and amplifying unit 324 can be set to zero, if the modulating and amplifying unit 310 does not require any compensation in the third signal region 802.
The peak compensation in the fourth signal region 804 depends on a saturation characteristic Vout = f(r) of the modifying and amplifying unit 310. The saturating characteristic is approximated by a polynomial in r:

$$f(r(t)) = \beta_0 + \beta_1 r(t) + \beta_2 r(t)^2 + \beta_3 r(t)^3 + \beta_4 r(t)^4 + \ldots \qquad , \qquad (7)$$

wherein the coefficients $\beta_0$, $\beta_1$,... are stored in the feeding unit 312.
The phase $\sigma(t)$ in equations (5) and (6) is a phase delay from the input to the output of the modulating and amplifying unit 310.
As can be gathered from the set of equations (6), a modulation phase $\psi$ equals the counter phase $\varphi_0$ in the

first signal region 502 and the second signal region 504 to cancel the distortion component of the offset signal, while the modulation phase ψ equals the phase signal φ of the baseband signal 304 outside the second signal region 504.

The radio frequency signal 302 resulting from merging together the preliminary radio frequency signal 318 denoted by Mout and the compensation signals 320, 321 denoted by Aout thus is

$$Tx(t) = Mout(t) + Aout(t) = k \cdot r(t)\cos\big[\omega(t) + \varphi(t) + \sigma(t)\big] \qquad (8)$$

Accordingly, the optimized and enhanced radio frequency signal 302 is linearly amplified in all five signal regions. Since the offset compensation signal 320 and the peak compensation signal 321 are generated and fed into the preliminary radio frequency signal 318 in mutually exclusive states of operation (namely the first signal region 502 and the second signal region 504 on the one hand, and the fourth signal region 804 and the fifth signal region 806 on the other hand) the same hardware can be re-used for generating and feeding the compensation signals 320, 321.

Feeding the peak compensation signal 321 into the generated preliminary radio frequency signal 318 may further include a weighted combination of the peak compensation signal 321 and the preliminary radio frequency signal 318. There are many ways to combine outputs by addition. In one example, each of the preliminary radio frequency signal 318 and the peak compensation signal 321 may obey a respective polynomial function (e.g., based on f(r) described above) of the amplitude, r, that increases between the saturation amplitude and the clipping amplitude. As an advantage, both of the outputs (i.e., the preliminary radio frequency signal 318 and the compensation signal) are continuous and/or smooth. The weighted combination may suppress unwanted distortions by a continuous or smooth combination as the amplitude of the baseband signal changes. E.g., the smooth combination may include continuous derivatives of first or second order with respect to the amplitude of the baseband signal.

The method 400 may further comprise a step of calibrating one or more weighting coefficients of the weighted combination. At least one of the one or more weighting coefficients may define a gain of the peak compensation signal that is fed into the preliminary radio frequency signal 318. The calibration may be static or dynamic. The one or more weighting coefficients may be calibrated so that the weighted combination provides a linear frequency translation of the baseband signal also at an upper limit of the third signal region and/or in the fourth signal region. The one or more weighting coefficients may further be calibrated so that out-off-band emissions are minimized.

The method 400 may further comprise a case differentiation depending on the amplitude signal r. In case the amplitude signal r is smaller than the activation amplitude $r_{min}$, the steps 410, 420, 430 and 440 are performed as described above. In case the amplitude signal r of the baseband signal 304 is greater than the saturation amplitude $r_s$, the method may further comprise the steps of providing the amplitude signal r and the phase signal φ depending on the baseband signal 304, modulating the phase signal φ to the carrier frequency $\omega_c$, amplifying the modulating phase signal according to the amplitude signal r to generate the preliminary radio frequency signal 318, and feeding the peak compensation signal 321, which depends on the baseband signal 304, into the preliminary radio frequency signal 318, wherein the peak compensation signal 321 is configured to at least essentially compensate for a saturation in the amplification step.

The case differentiation is described in more detail below.

First and second signal regions:

When the amplitude signal fulfills r(t) < $r_{min}$, the trajectory 200 potentially also enters the neighborhood of the origin, i.e., the first signal region 502, in which the bandwidth expansion occurs. The offset signal 314 is inserted as an offset sequence including offset samples, each of which is computed according to the equations (3) and (4) or (4b) to reduce the bandwidth expansion introduced by the Cartesian to polar coordinate conversion performed by the providing unit 308. This reduces the bandwidth requirements of both an amplitude signal path and a phase signal path, and makes polar modulation possible even for wideband applications such as LTE. After polar modulation, i.e., downstream to the modulating and amplifying unit 310, the distortion component corresponding to the inserted offset signal 314 is removed from the preliminary radio frequency signal 318 by adding a negative modulating signal ro(t) · $e^{j\theta o(t)}$ that is created by the auxiliary modulating and amplifying unit 324. Consequently, both units 310 and 324 operate in the second signal region 504. The overall time average probability for operating in this state is fairly low. In more advanced embodiments of the device 300 and the method 400, the activation amplitude $r_{min}$ changes according to different transmission power levels and different modulation methods, e.g., QPSK, 16QAM, etc.

Third signal region:

The third signal region 802 is a region of linear operation of the modulating and amplifying unit 310 and defined by the amplitude signal fulfilling $r_{min} \leq r(t) \leq r_s$. The trajectory 200 is outside both the second signal region 504 and the fourth signal region 804, so that there is neither bandwidth expansion nor amplitude clipping. In the third signal region 802, only the modulating and amplifying unit 310 operates, which is optimized to have good power efficiency in the third signal region 802. In case the modulating and amplifying unit 310 requires any compensation or does not meet the requirements as to signal quality for the radio standard that is adopted, the above-mentioned compensation signal, o(t), which is output by the auxiliary modulating and amplifying unit 324, compensates for imperfections introduced by the modulating and amplifying unit 310. The saturation amplitude $r_s$ defining the upper limit of the third signal region 802 is a pre-defined value that determines when the auxiliary modulating and amplifying unit 324 is to be powered-on to provide the enhancing output signal power of the peak compensation signal 321. The probability for operating in the third signal region 802 is very high. Consequently, the power efficiency of the device 300 and the method 400 is mainly determined by the good power efficiency in the third signal region 802.

Fourth signal region:

When the amplified signal fulfills $r_s \leq r(t) \leq r_{max}$, the trajectory 200 is far away from the constellation origin but close to the saturated power level of the modulating and amplifying unit 310. A hard amplitude clipping occurs in the modulating and amplifying unit 310, if the amplitude signal further increases to the clipping amplitude $r_{max}$. In the fourth signal region 804, the modulating and amplifying unit 310 operates to its maximum output signal power level and the auxiliary modulating and amplifying unit 324 operates at a fraction of its maximum output signal power capability providing a relatively weak power Aout as the peak compensation signal 321 determined by kr(t)-f(r(t)), which is shown in Fig. 9(b). The peak compensation signal 321 compensates for the beginning saturation of the modulating and amplifying unit 310, so that the radio frequency signal 302 is linearized. Since the operation in the fourth signal region 804 only occurs when the required transmission power level is very large and close to the saturated power level $kr_{max}$, the probability for operating in the fourth signal region 804 is very low.

Fifth signal region:

The fifth signal region 806 corresponds to a peak region in the baseband signal 304 when its amplitude signal is $r(t) > r_{max}$. The trajectory 200 enters a peak segment p1-Tp-p2 shown in Fig. 8. The modulating and amplifying unit 310 has a saturated power level and the auxiliary modulating and amplifying unit 324 provides an additional linear output to enhance the total power level of the radio frequency signal 302. Both of the units 310 and 324 contribute to the output power. As the units 310 and 324 apply power to the output side of each other, the power efficiency drops in the fifth signal region 806. To the benefit of the overall power efficiency, the probability for operating in the fifth signal region 806 is extremely low according to the exponentially suppressed probability shown in Fig. 7. Consequently, the contribution of the fifth signal region 806 to the overall power efficiency of the device 300 and the method 400 is almost negligible.

In order to avoid a quick or sharp clip, the peak compensation signal 321 may further be configured to modify the preliminary radio frequency signal 318 (i.e., the output of the amplification) to approach the maximum output signal level of the preliminary radio frequency signal (i.e., the output level corresponding to the lower limit of the fifth signal region 806) with a predefined transition time or a finite time constant.

The benefit of the transition in the fourth signal region 804 can be understood from Fig. 8. According to equations (5) and (6), when the amplitude of the baseband signal 304 is larger than $r_s$, the baseband signal 304 is split into two signals. For example, the baseband signal OQ, which is shown in Fig. 8, can be split into OP and PQ both with the same phase φ. If the transition region does not exist, the trajectory T1-a-p1-Tp-p2-d-T2 is decomposed into T1-a-p1-p2-d-T2 for the modulating and amplifying unit 310 and p1-Tp-p2 for the auxiliary modulating and amplifying unit 324, respectively. Consequently, a change of directions in a-p1-p2-d is too sharp and requires too wide bandwidth for cost-effective implementations.

With the transition defined in the fourth region 804, $r_s \leq r(t) \leq r_{max,}$ the trajectory T1-a-p1-Tp-p2-d-T2 is decomposed into T1-a-b-c-d-T2 for the modulating and amplifying unit and a-p1-Tp-p2-d for the auxiliary modulating and amplifying unit 324, respectively, thus making the transition smoother. The smooth transition implies more relaxed bandwidth requirements for implementations and lower distortion levels created in both amplitude and phase paths.

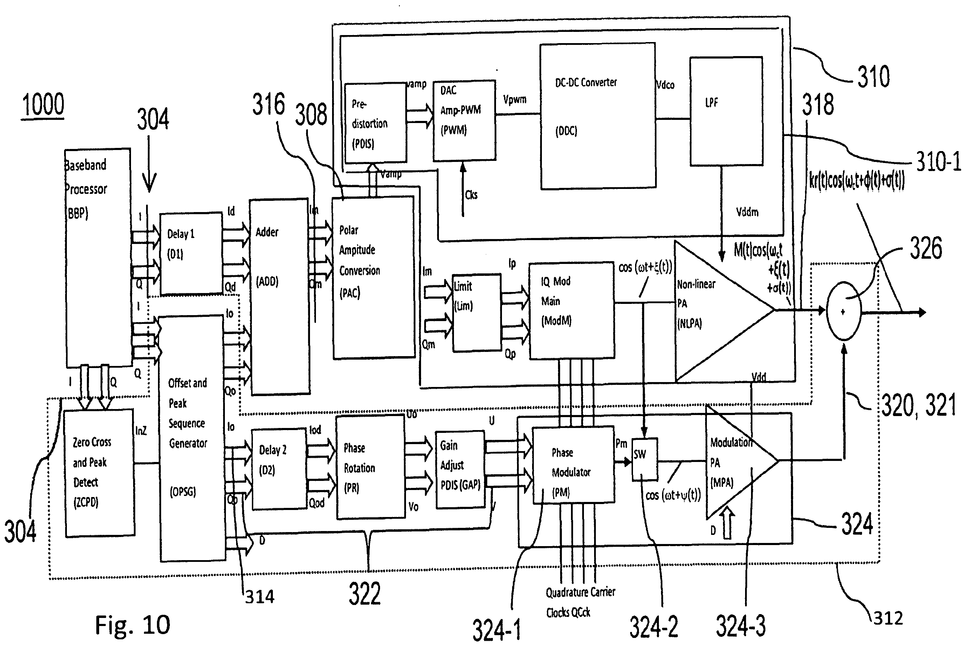

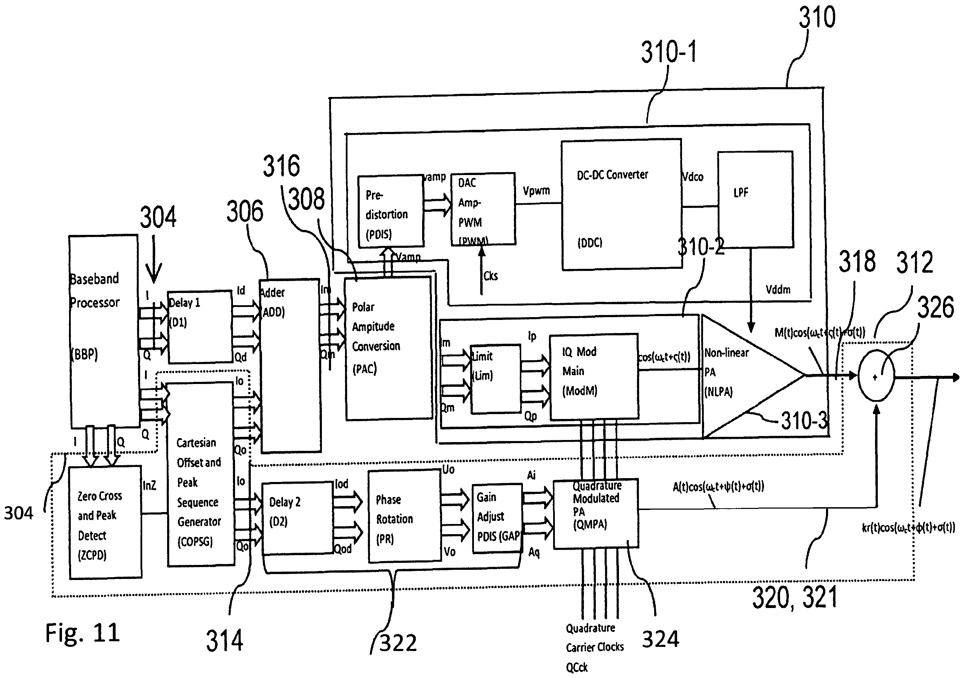

The Figs. 10 and 11 show more detailed block diagrams that schematically illustrate a first embodiment 1000 and a second embodiment 1100, respectively, of the device 300 for generating the radio frequency signal 302 based on the baseband signal 304 described above. Like reference signs denote implementations of units described above with reference to Fig. 3, a repetitive description of which is avoided here.

In both embodiments 1000 and 1100, the modulating and amplifying unit 310 includes an amplitude signal path 310-1, a phase signal path 310-2 and a supply-modulated power amplifier 310-3 operative in a power-efficient non-linear mode. The power efficiency may correspond to a class E or F power amplifier operation. The amplitude M of the preliminary radio frequency signal 318 is a function of the supply voltage Vddm of the supply modulation. Optionally, a phase compensation cancels phase errors during amplitude modulation.

The amplitude signal path 310-1 includes a pre-distortion unit (PDIS), a digital-to-analog conversion unit (DAC), and a pulse width modulation unit (PWM), through which the amplitude signal of the baseband signal 304 is converted into a pulse sequence Vpwm. The pulse sequence Vpwm has a duty cycle that is a function of the baseband amplitude signal Vamp. The pulse sequence Vpwm controls a DC-DC converter (DDC) and creates an output voltage Vdco. A DC component in the voltage Vdco is proportional to the voltage Vamp. A low pass filter (LPF) removes all unwanted high-frequency components in the voltage signal Vdco in order to reduce out-off band emissions and spurious emissions, which are harmful for adjacent channels and for the receiver inside a mobile device including the device 300, respectively. The effect of the amplitude signal path 310-1 is the provision of a supply voltage Vddm configured to modulate the power amplifier 310-3 so that the amplitude M of the preliminary radio frequency signal 318 is proportional to the amplitude Vamp = |I(t)+jQ(t)| of the I and Q components provided by the providing unit 308 to the unit 310. The components in the amplitude signal path 310-1 are optimized for reaching high power efficiency.

In the phase signal path 310-2 of the unit 310, a limiter is employed to create a quadrature-modulated phase signal with components Ip and Qp received by an IQ modulation main unit (ModM). The limiter can be implemented in either an analog or digital manner. In a digital limiter, the components Ip and Qp of the normalized quadrature-modulated phase signal are created by

$$Ip(t) = \frac{\mathrm{Im}(t)}{\sqrt{\mathrm{Im}(t)^2 + Qm(t)^2}}$$

$$Qp(t) = \frac{Qm(t)}{\sqrt{\mathrm{Im}(t)^2 + Qm(t)^2}} . \tag{9}$$

Thus, the amplitude of the phase signal (Ip + j·Qp) represented by the pair of Ip and Qp components is normalized to one.

In IQ modulation Main (ModM), the phase signal is modulated to the carrier frequency, $\omega_c$ = 2nfc, creating the voltage Vp of the modulated phase signal:

$$Vp(t) = Ip(t)\cos(\omega_c t) - Qp(t)\sin(\omega_c t)$$

$$= \cos(\omega_c t + \xi(t))$$

$$\xi(t) = \arctan\left(\frac{Qp(t)}{Ip(t)}\right) . \tag{10}$$

In the power amplifier 310-3, the modulated phase signal provided by the phase signal path 310-2 is amplified to the amplitude M proportional to Vamp, which in turn determines Vddm.

In both embodiments 1000 and 1100, a zero cross and peak detector (ZCPD) performs the above-described case differentiation by detecting data segments in the baseband signal 304 according to the amplitude signal r of the components I and Q.

When the amplitude signal r is very close to the first signal region 502, in which bandwidth expansion would occur for polar-modulated signals, the Offset and Peak Sequence Generator (OPSG) creates an offset sequence, which is added to the original I and Q signals via the first adder 306 and forces the modified signals Im and Qm away from the first signal region 502. OPSG also creates an amplitude signal D=D(1:n), which is a digital vector. The modified signals Im and Qm are converted to the modified baseband amplitude signal Vamp, from Cartesian coordinates to polar coordinates, i.e., $V_{amp} = \sqrt{I_m^2 + Q_m^2}$, by means of a Polar Amplitude Conversion (PAC) implementing the providing unit 308.

When the amplitude of the baseband signal 304 has a peak amplitude exceeding the saturation amplitude $r_s$, the ZCPD will detect the fourth or fifth signal regions 804, 806 and signal the OPSG to split the input signal into two parts: one for the power amplifier 310-3 and one for the feeding unit 312.

In both embodiments 1000 and 1100, the alignment unit 322 includes a delay unit (D2), a phase rotation unit (PR), and a gain adjustment unit (GAP). In the case of the fourth or fifth signal region 804, 806, the OPSG creates an amplitude control vector A, which controls the gain of the auxiliary modulating and amplifying unit 324 by means of the gain adjustment unit (GAP).

In the embodiment 1000, the auxiliary modulating and amplifying unit 324 includes a phase modulator 324-1, a switch 324-2 and a modulation power amplifier 324-3. The digital vector D of the OPSG is provided to the modulation power amplifier 324-3, which may also be referred to as an auxiliary power amplifier.

The modulation power amplifier 324-3 can be implemented in either digital or analog manner. For instance, a Gilbert mixer/modulator can be used in an analog implementation. For peak compensation, a radio frequency amplifier is normally required to amplify the signal power.

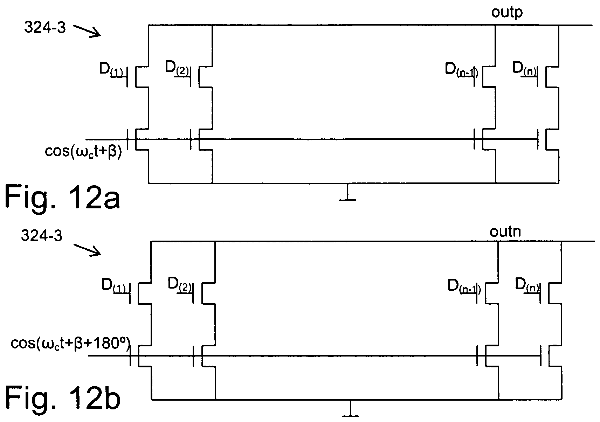

A digital quadrature-modulated differential power amplifier may be used in the embodiment 1000 built with a pair of differential quadrature modulators. One of the differential quadrature modulators is shown in the Figs. 12a and 12b, for positive and negative parts, respectively.

In the positive part, one of a quadrature radio carrier frequency signal or Local Oscillator (LO) clock signal, $\cos(\omega_c t+\beta)$, is connected to the gates of bottom transistors in n transistor branches, as is shown in Fig. 12a. The gates of the top transistors are connected to a digital amplitude control vector signal, D(1,2,...,n), in a weighted manner, such as a binary code or by other means. A branch can be enabled only when the corresponding control bit is set to logic high, otherwise it is disabled. Thus, the output of the power amplifier is proportional to the weighted factor determined by the amplitude control vector signal D.

In a similar way, the negative part uses the corresponding quadrature LO signal $\cos(\omega_c+\beta+180°)$, as is shown in Fig. 12b, to yield a "negative" output (denoted by "outn" in Fig. 12b).

For a quadrature-modulated differential power implementation, the pair of differential quadrature modulators preferably uses a pair of control vectors, D=[Di,Dq], and quadrature LO clocks to create output. The two differential quadrature modulators are connected to Di and Dq, respectively. The two differential quadrature modulators are driven by quadrature clocks $\pm\sin(\omega_c t+\beta)$ and $\pm\cos(\omega_c t+\beta)$, respectively. The outputs of the two differential quadrature modulators are connected together. As a result, the preliminary radio frequency signal 318 is created based on a quadrature-weighted current sum.

When the auxiliary power amplifier is used for both the offset compensation and the peak compensation, the clock phases depend on the amplitude signal. The clock phases thus differ for offset compensation and peak compensation.

For peak compensation the phase of the auxiliary power amplifier and the main power amplifier may be ideally the same. An advanced implementation accounts for a slight delay difference or phase skew between the main power amplifier and the auxiliary power amplifier, e.g., depending on the types and/or the number of stages of the power amplifiers. A tunable delay unit is employed in the advanced implementation to compensate the delay difference. In all implementations, phases of the clocks used for the main power amplifier and auxiliary power amplifier can be taken from one source for the peak compensation.

For the offset compensation, the phase signal of the auxiliary power amplifier may be approximately perpendicular to the phase signal of the main power amplifier, according to Fig. 6 and Eq. (4b). As a consequence, the clock signal for the auxiliary power amplifier may also be derived from a single source, including a pi/2-phase shift for the auxiliary power amplifier. In such a case, a switch may be introduced to create an output clock by swapping between in-phase and quadrature-phase so that the clock signals used in the auxiliary power amplifier are toggled between offset compensation and peak compensation.

The embodiment 1100 uses a quadrature modulated power amplifier as the auxiliary modulating and amplifying unit 324. The embodiment 1100 further differs from the embodiment 1000 in that the OPSG is replaced by a Cartesian Offset and Peak Sequence Generator (COPSG), in which both offset sequence signals and peak enhancement signals are generated only in Cartesian coordinates.

Accordingly, the quadrature modulated power amplifier 324 used in the embodiment 1100 provides the compensation signal 320 or 321 according to:

$$A(t)e^{-j[\omega t+\psi(t)+\sigma(t)]} = k\left[A_i(t)+j\cdot A_q(t)\right]e^{-j[\omega t+\sigma(t)]} = \left[A(t)\cos(\psi(t))+j\cdot A(t)\sin(\psi(t))\right]e^{-j[\omega t+\sigma(t)]}$$

$$\left[A_i(t)+j\cdot A_q(t)\right]=\begin{cases} -\left[Io(t)+jQo(t)\right], & \left|I(t)+jQ(t)\right|<r_{min} \\ o(t), & r_{min}<\left|I(t)+jQ(t)\right|<r_s \\ I(t)+jQ(t)-f(I(t)+jQ(t)), & r_s<\left|I(t)+jQ(t)\right|<r_{max} \\ I(t)-r_{max}\cos(\varphi(t))+jQ(t)-j\cdot r_{max}\sin(\varphi(t)), & r_{max}<\left|I(t)+jQ(t)\right| \end{cases}$$

*where*

$$\varphi(t) = \arctan(\frac{Q(t)}{I(t)}) \qquad\qquad\qquad . \ (11)$$

It is to be emphasized that the embodiments 1000 and 1100 are combinable. For example, the power amplifier 310-3 of the modulating and amplifying unit 310 is implemented in a combined embodiment by means of the modified polar modulation (as described for the embodiments 1000 and 1100), and the auxiliary modulating and amplifying unit 324 includes a mixed-mode modulator, in which both the polar modulation and the quadrature modulation are implemented. The polar modulation and the quadrature modulation are employed for the first and second signal regions and for the fourth and fifth signal regions, respectively, or the other way around.

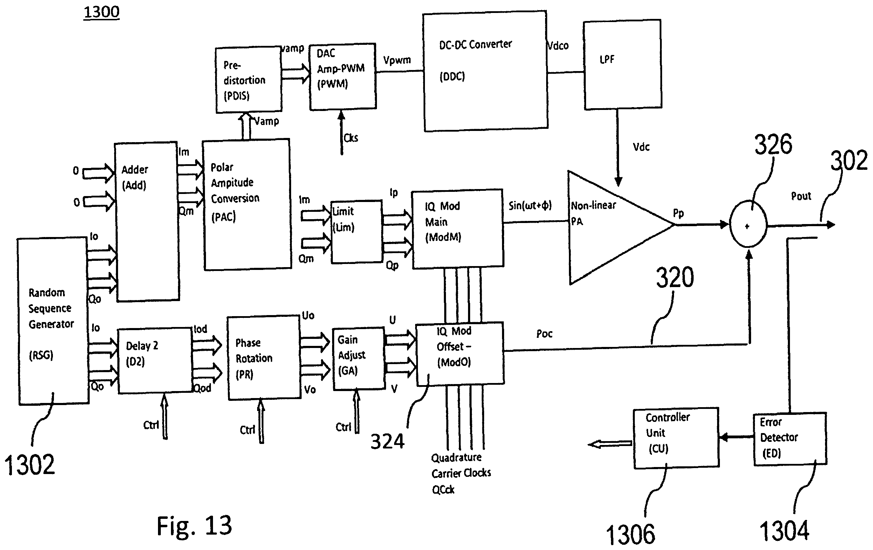

Fig. 13 shows an advanced variation 1300 of the embodiment 1100 that can be used for a calibration of the alignment setting 328 in the alignment unit 322. A random sequence generator 1302 generates a test signal, a pulse sequence with known repeating pattern or a pseudo random sequence with components Io and Qo replacing the narrowband offset sequence of the offset signal 314. One of the inputs of the first adder (which is used as the modifying unit 306) is set to zero. An error detector unit 1304 is configured to couple to the radio frequency signal 302 resulting from both the modulating and amplifying unit 310 and the auxiliary modulating and amplifying unit 324. A controller unit 1306 provides a binary control vector as the alignment setting 328. Each of the components of the binary control vector controls a respective one of the delay unit D2, the phase rotation unit PR and the gain adjustment unit GA of the alignment unit 352. The control unit 1306 is configured to provide the binary control vector so as to minimize the output power received via the error detector unit 1304. The signal amplitude of the pseudo random sequence must be so weak such that the spurious emission due to its wide spectrum will not exceed the spectral mask required by different radio standards.

This calibration can be carried out "statically", i.e., before the transmitter operates. Alternatively or in addition, the calibration can be carried out "dynamically", i.e., during the transmission when the baseband signal is not in the first or second signal regions (when there is no need for an offset sequence performing offset cancellation).

For the calibration before transmission, a weak test signal is generated by the random sequence generator 1302 and fed into the modulating and amplifying unit 310 and the auxiliary modulating and amplifying unit 324. The contributions output from the modulating and amplifying unit 310 and the auxiliary modulating and amplifying unit 324 should cancel each other in the second adder 326, if the calibration of the alignment setting 328 is perfect. In practice, when calibration is not perfect, there will be a residual error in the output radio frequency signal 302 detected by the error detector unit 1304. The error detector unit 1304 reports an error amplitude to the controller unit 1306, based on which the controller unit 1306 provides the binary control vector so as to reduce the residual error until it meets predefined requirements.

For the calibration during transmission, the weak test signal can be modulated at an intermediate frequency that is higher than a frequency difference of duplexing in an adopted Frequency-Division Duplexing (FDD) standard, so the calibration signal will not overlap with the receiver band and degrade the receiver sensitivity.

The error detector unit 1304 can be implemented in different ways. In one variant, the error detector unit 1304 includes a correlation detector, which provides a maximum gain (and thus a maximum error amplitude) for the pulse sequence with known repeating pattern or for the pseudo random sequence, whereas the correlation detector is essentially insensitive to the radio frequency signal 302 to be transmitted.

As has become apparent, a requirement of high linearity in a transmitter chain can be combined with requirements as to high power efficiency using at least some of the above-described embodiments. Even if there was some non-linear interaction between the modulating and amplifying unit 310 and the auxiliary modulating and amplifying unit 324 due to their coupled outputs via the second adder 326, the benefit for both offset compensation and peak compensation can be substantial. If, for example, the offset sequence 314 that is introduced results in an EVM of 10% in the preliminary radio frequency signal 318 and the level of cancellation is, e.g., 80%, the EVM after cancellation remaining in the radio frequency signal 302 is only 2%. In practice, aligning a delay mismatch between the modulating and amplifying unit 310 and the auxiliary modulating and amplifying unit 324 and adjusting the gain in the alignment unit 322 is relatively easy. While maintaining the phase alignment in the alignment setting 328 may be more demanding, the above numerical example illustrates that the cancellation is substantial, even if it is not perfect. Assuming, e.g., 80% cancellation with the remaining part originating from an incorrect phase setting in the alignment setting 328, a phase error up to 6 degrees can be acceptable.

The bandwidth expansion problem in polar modulation has been solved in at least some of the embodiments by adding an offset sequence before a transformation from quadrature modulation to polar modulation, which avoids sharp changes in both amplitude and phase paths. The distortion reducing signal quality in terms of EVM or ACLR caused by the introduced offset sequence is removed by combining the preliminary radio frequency signal with a negative offset compensation signal.

While the power efficiency of polar modulation could not be harnessed in a conventional transmitter design for wideband LTE, at least some of above embodiments can be used for wideband LTE application with a bandwidth up to 20 MHz. As a result, the power efficiency of an up-link connection for a mobile device can be improved.

The auxiliary modulating and amplifying unit and the corresponding second adder are re-used for both offset cancellation and peak enhancement, because former and latter never happen at the same time, so that the hardware design is compact and cost-efficient.

In general, all kinds of imperfections introduced by the modulating and amplifying unit can be reduced or eliminated by the auxiliary modulating and amplifying unit.

While the disclosure has been described with reference to particular embodiments, it will be readily apparent to those skilled in the art that it is possible to embody the invention in specific forms other than those of the embodiments described above. The described embodiments are merely illustrative and should not be considered restrictive in any way. Rather, the scope of the invention is given by the appended claims.

**Claims**

1. A method (400) of generating a radio frequency signal (302) based on a baseband signal (304), the method comprising:

   - modifying (410) the baseband signal (304) by adding an offset signal (314) to the baseband signal (304), the offset signal (314) being configured to prevent the modified baseband signal (316) from entering a first signal region (502);
   - providing (420) an amplitude signal (r; Vamp; Vddm) and a phase signal ($\varphi$; [Ip,Qp]) based on the modified baseband signal (316);
   - modulating (430) the phase signal ($\varphi$; [Ip,Qp]) to a carrier frequency ($\omega_c$) and amplifying the modulated phase signal according to the amplitude signal (r; Vamp; Vddm) to generate a preliminary radio frequency signal (318); and
   - feeding (440) an offset compensation signal (320) derived from the offset signal (314) into the preliminary radio frequency signal (318) to generate the radio frequency signal (302), wherein the offset compensation signal (320) is configured to at least essentially cancel a distortion component, which corresponds to the offset signal (314), in the preliminary radio frequency signal (318).

2. The method of claim 1, wherein the modification step (410) is performed and the offset compensation signal is derived from the offset signal (314), if the baseband signal (304) is in a second signal region (504), wherein a minimum amplitude (R) defines an upper limit of the first signal region (502) and an activation amplitude ($r_{min}$) defines an upper limit of the second signal region (504).

3. The method of claim 1 or 2, wherein at least one of the first signal region (502) and the second signal region (504) changes depending on an output signal level of the radio frequency signal (302) and/or a modulation scheme applied for the baseband signal (304).

4. The method of any one of claims 1 to 3, wherein at least one of the modulation and the amplification is performed by operating a component (310; 310-3) in a non-linear mode or in a switched mode.

5. The method of claim 4, wherein the amplitude signal (r; Vamp; Vddm) depends on the baseband signal (304) such that the radio frequency signal (302) is at least essentially a linear frequency translation of the baseband signal (304).

6. The method of any one of claims 1 to 5, wherein essentially no offset signal (314) is added, if the baseband signal (304) is in a third signal region (802).

7. The method of any one of claims 1 to 6, further comprising:

   - feeding a peak compensation signal (321) derived from the baseband signal (304) into the preliminary radio frequency signal (318), wherein the peak compensation signal (321) at least essentially compensates for a saturation in the amplification, if the baseband signal (304) is in a fourth signal region (804) or a fifth signal region (806).

8. The method of claim 7, wherein feeding the peak compensation signal (321) into the preliminary radio frequency signal (318) further includes a weighted combination of the peak compensation signal (321) and the preliminary radio frequency signal (318).

9. The method of claim 8, further comprising:

- statically or dynamically calibrating one or more weight coefficients of the weighted combination.

10. The method of any one of claims 7 to 9, wherein a saturation amplitude ($r_s$) is at least one of an upper limit of the third signal region (802) and a lower limit of the fourth signal region (804).

11. The method of any one of claims 7 to 10, wherein the peak compensation signal (321) increases as a function of the baseband signal (304), if the baseband signal (304) is in the fifth signal region (806).

12. The method of any one of claims 7 to 11, wherein a clipping amplitude ($r_{max}$) defines a lower limit of the fifth signal region (806).

13. The method of any one of claims 7 to 12, wherein the peak compensation signal (321) is further configured to modify the preliminary radio frequency signal (318) so that an approach to the lower limit of the fifth signal region (806) has a predefined transition time.

14. The method of any one of claims 7 to 12, wherein the offset compensation signal (320) and the peak compensation signal (321) are generated by an auxiliary power amplifier (324; 324-3) and the phase signal ($\varphi$; [Ip,Qp]) is applied to the auxiliary power amplifier (324; 324-3) in at least one of the fourth signal region (804) and the fifth signal region (806).

15. The method of claim 14, wherein the auxiliary power amplifier (324; 324-3) may be a polar-modulated auxiliary power amplifier (324-3) or a quadrature-modulated auxiliary power amplifier (324).

16. The method of any one of claims 1 to 15, wherein the deriving of the offset compensation signal (320) includes aligning the offset compensation signal (320) relative to the preliminary radio frequency signal (318) according to an alignment setting (328), the method (400) further comprising:

- generating a calibration signal, which substitutes the offset signal (314) and from which the offset compensation signal (320) is derived according to the alignment setting (328);
- detecting a component, which corresponds to the calibration signal, in the radio frequency signal (302); and
- calibrating the alignment setting, wherein the calibration aims at reducing the detected component.

17. A device (300; 1000; 1100) for generating a radio frequency signal (302) based on a baseband signal (304), the device comprising:

- a modifying unit (306) adapted to modify the baseband signal (304) by adding an offset signal (314) to the baseband signal (304), the offset signal (314) being configured to prevent the modified baseband signal (316) from entering a first signal region (502);
- a providing unit (308) adapted to provide an amplitude signal (r; Vamp; Vddm) and a phase signal ($\varphi$; [Ip,Qp]) based on the modified baseband signal (316);
- a modulating and amplifying unit (310) adapted to modulate the phase signal ($\varphi$; [Ip,Qp]) to a carrier frequency ($\omega_c$) and to amplify the modulated phase signal according to the amplitude signal (r; Vamp; Vddm) to generate a preliminary radio frequency signal (318); and
- a feeding unit (312) adapted to feed an offset compensation signal (320) derived from the offset signal (314) into the preliminary radio frequency signal (318) to generate the radio frequency signal (302), wherein the offset compensation signal (320) is configured to at least essentially cancel a distortion component, which corresponds to the offset signal (314), in the preliminary radio frequency signal (318).

18. The device of claim 17, wherein the modifying unit (306) is activated and/or the offset compensation signal (320) is derived from the offset signal (314), if the baseband signal (304) enters a second signal region (504).

19. The device of claim 17 or 18, wherein the feeding unit (312) is at least essentially deactivated, if the baseband signal is in a third signal region (802).

20. The device of any one of claims 17 to 19, wherein the feeding unit (312) is further adapted to feed a peak compensation signal (321) derived from the baseband signal (304) into the preliminary radio frequency signal (318), wherein the peak compensation signal (321) at least essentially compensates for a saturation in the amplification, if the baseband signal (304) is in a fourth signal region (804) or a fifth signal region (806).

21. The device of any one of claims 17 to 20, wherein the feeding unit (312) includes an alignment unit (322) adapted to align the offset compensation signal (320) relative to the preliminary radio frequency signal (318) according to an alignment setting (328), the device (300; 1000; 1100) further comprising:

   - a generating unit (1302) adapted to generate a calibration signal, which substitutes the offset signal (314) and from which the offset compensation signal (320) is derived according to the alignment setting (328);
   - a detecting unit (1304) adapted to detect a component, which corresponds to the calibration signal, in the radio frequency signal (302); and
   - a calibrating unit (1306) adapted to calibrate the alignment setting, wherein the calibration aims at reducing the detected component.

## Patentansprüche

1. Verfahren (400) zur Erzeugung eines Funkfrequenzsignals (302) auf der Basis eines Basisbandsignals (304), das Verfahren umfassend:

   - Modifizieren (410) des Basisbandsignals (304) durch Hinzufügen eines Versatzsignals (314) zum Basisbandsignal (304), wobei das Versatzsignal (314) konfiguriert ist, das modifizierte Basisbandsignal (316) vom Eintreten in einen ersten Signalbereich (502) abzuhalten;
   - Bereitstellen (420) eines Amplitudensignals ($r$; Vamp; Vddm) und eines Phasensignals ($\varphi$; [Ip,Qp]) auf der Basis des modifizierten Basisbandsignals (316) ;
   - Modulieren (430) des Phasensignals ($\varphi$; [Ip,Qp]) zu einer Trägerfrequenz ($\omega_c$) und Verstärken des modulierten Phasensignals gemäß dem Amplitudensignal ($r$; Vamp; Vddm), um ein vorläufiges Funkfrequenzsignal (318) zu erzeugen; und
   - Speisen (440) eines Versatzkompensationssignals (320), das vom Versatzsignal (314) abgeleitet ist, in das vorläufige Funkfrequenzsignal (318), um das Funkfrequenzsignal (302) zu erzeugen, wobei das Versatzkompensationssignal (320) konfiguriert ist, mindestens wesentlich eine Verzerrungskomponente, die dem Versatzsignal (314) entspricht, im vorläufigen Funkfrequenzsignal (318) zu löschen.

2. Verfahren nach Anspruch 1, wobei der Modifizierungsschritt (410) ausgeführt wird und das Versatzkompensationssignal vom Versatzsignal (314) abgeleitet wird, falls das Basisbandsignal (304) in einem zweiten Signalbereich (504) ist, wobei eine minimale Amplitude ($R$) eine Obergrenze des ersten Signalbereichs (502) definiert und eine Aktivierungsamplitude ($r_{min}$) eine Obergrenze des zweiten Signalbereichs (504) definiert.

3. Verfahren nach Anspruch 1 oder 2, wobei sich mindestens einer von dem ersten Signalbereich (502) und zweiten Signalbereich (504) abhängig von einem Ausgangssignalwert des Funkfrequenzsignals (302) und/oder einem Modulationsschema, das für das Basisbandsignal (304) angewendet wird, ändert.

4. Verfahren nach einem der Ansprüche 1 bis 3, wobei mindestens eine von der Modulation und der Verstärkung durch Betreiben einer Komponente (310; 310-3) in einem nichtlinearen Modus oder in einem geschalteten Modus ausgeführt wird.

5. Verfahren nach Anspruch 4, wobei das Amplitudensignal ($r$; Vamp; Vddm) vom Basisbandsignal (304) abhängt, sodass das Funkfrequenzsignal (302) mindestens im Wesentlichen eine lineare Frequenzübersetzung des Basisbandsignals (304) ist.

6. Verfahren nach einem der Ansprüche 1 bis 5, wobei im Wesentlichen kein Versatzsignal (314) hinzugefügt ist, falls das Basisbandsignal (304) in einem dritten Signalbereich (802) ist.

7. Verfahren nach einem der Ansprüche 1 bis 6, des Weiteren umfassend:

   - Speisen eines Spitzenkompensationssignals (321), das vom Basisbandsignal (304) abgeleitet ist, in das vorläufige Funkfrequenzsignal (318), wobei das Spitzenkompensationssignal (321) mindestens im Wesentlichen eine Sättigung in der Verstärkung kompensiert, falls das Basisbandsignal (304) in einem vierten Signalbereich (804) oder einem fünften Signalbereich (806) ist.

8. Verfahren nach Anspruch 7, wobei das Speisen des Spitzenkompensationssignals (321) in das vorläufige Funkfrequenzsignal (318) des Weiteren eine gewichtete Kombination des Spitzenkompensationssignals (321) und des vorläufigen Funkfrequenzsignals (318) enthält.

9. Verfahren nach Anspruch 8, des Weiteren umfassend:

   - Statisches oder dynamisches Kalibrieren eines oder mehrerer Gewichtskoeffizienten der gewichteten Kombination.

10. Verfahren nach einem der Ansprüche 7 bis 9, wobei eine Sättigungsamplitude ($r_s$) mindestens eine von einer Obergrenze des dritten Signalbereichs (802) und einer Untergrenze des vierten Signalbereichs (804) ist.

11. Verfahren nach einem der Ansprüche 7 bis 10, wobei das Spitzenkompensationssignal (321) als eine Funktion des Basisbandsignals (304) zunimmt, falls das Basisbandsignal (304) im fünften Signalbereich (806) ist.

12. Verfahren nach einem der Ansprüche 7 bis 11, wobei eine Begrenzungsamplitude ($r_{max}$) eine Untergrenze des fünften Signalbereichs (806) definiert.

13. Verfahren nach einem der Ansprüche 7 bis 12, wobei das Spitzenkompensationssignal (321) des Weiteren konfiguriert ist, das vorläufige Funkfrequenzsignal (318) zu modifizieren, sodass eine Annäherung an die Untergrenze des fünften Signalbereichs (806) eine vorbestimmte Übergangszeit hat.

14. Verfahren nach einem der Ansprüche 7 bis 12, wobei das Versatzkompensationssignal (320) und das Spitzenkompensationssignal (321) durch einen Hilfsleistungsverstärker (324; 324-3) erzeugt sind und das Phasensignal ($\varphi$; [Ip,Qp]) an den Hilfsleistungsverstärker (324; 324-3) in mindestens einem von dem vierten Signalbereichs (804) und fünften Signalbereich (806) angelegt ist.

15. Verfahren nach Anspruch 14, wobei der Hilfsleistungsverstärker (324; 324-3) ein polarmodulierter Hilfsleistungsverstärker (324-3) oder ein quadraturmodulierter Hilfsleistungsverstärker (324) sein kann.

16. Verfahren nach einem der Ansprüche 1 bis 15, wobei das Ableiten des Versatzkompensationssignals (320) ein Ausrichten des Versatzkompensationssignals (320) relativ zum vorläufigen Funkfrequenzsignal (318) gemäß einer Ausrichtungseinstellung (328) enthält, das Verfahren (400) des Weiteren umfassend:

   - Erzeugen eines Kalibrierungssignals, das das Versatzsignal (314) ersetzt und von dem das Versatzkompensationssignal (320) gemäß der Ausrichtungseinstellung (328) abgeleitet ist;
   - Erfassen einer Komponente, die dem Kalibrierungssignal entspricht, im Funkfrequenzsignal (302); und
   - Kalibrieren der Ausrichtungseinstellung, wobei die Kalibrierung darauf abzielt, die erfasste Komponente zu reduzieren.

17. Vorrichtung (300; 1000; 1100) zur Erzeugung eines Funkfrequenzsignals (302) auf der Basis eines Basisbandsignals (304), die Vorrichtung umfassend:

   - eine Modifikationseinheit (306), die angepasst ist zum Modifizieren des Basisbandsignals (304) durch Hinzufügen eines Versatzsignals (314) zum Basisbandsignal (304), wobei das Versatzsignal (314) konfiguriert ist, das modifizierte Basisbandsignal (316) vom Eintreten in einen ersten Signalbereich (502) abzuhalten;
   - eine Bereitstellungseinheit (308), die angepasst ist zum Bereitstellen eines Amplitudensignals (r; Vamp; Vddm) und eines Phasensignals ($\varphi$; [Ip,Qp]) auf der Basis des modifizierten Basisbandsignals (316);
   - eine Modulations- und Verstärkungseinheit (310), die angepasst ist zum Modulieren des Phasensignals ($\varphi$; [Ip,Qp]) zu einer Trägerfrequenz ($\omega_c$) und Verstärken des modulierten Phasensignals gemäß dem Amplitudensignal (r; Vamp; Vddm), um ein vorläufiges Funkfrequenzsignal (318) zu erzeugen; und
   - eine Speisungseinheit (312), die angepasst ist zum Speisen eines Versatzkompensationssignals (320), das vom Versatzsignal (314) abgeleitet ist, in das vorläufige Funkfrequenzsignal (318) um das Funkfrequenzsignal (302) zu erzeugen, wobei das Versatzkompensationssignal (320) konfiguriert ist, mindestens wesentlich eine Verzerrungskomponente im vorläufigen Funkfrequenzsignal (318) zu löschen, die dem Versatzsignal (314) entspricht.

**18.** Vorrichtung nach Anspruch 17, wobei die Modifikationseinheit (306) aktiviert wird und/oder das Versatzkompensationssignal (320) vom Versatzsignal (314) abgeleitet wird, falls das Basisbandsignal (304) in einen zweiten Signalbereich (504) eintritt.

**19.** Vorrichtung nach Anspruch 17 oder 18, wobei die Speisungseinheit (312) mindestens im Wesentlichen deaktiviert wird, falls das Basisbandsignal in einem dritten Signalbereich (802) ist.

**20.** Vorrichtung nach einem der Ansprüche 17 bis 19, wobei die Speisungseinheit (312) des Weiteren angepasst ist, ein Spitzenkompensationssignal (321), das vom Basisbandsignal (304) abgeleitet ist, in das vorläufige Funkfrequenzsignal (318) zu speisen, wobei das Spitzenkompensationssignal (321) mindestens im Wesentlichen eine Sättigung in der Verstärkung kompensiert, falls das Basisbandsignal (304) in einem vierten Signalbereich (804) oder einem fünften Signalbereich (806) ist.

**21.** Vorrichtung nach einem der Ansprüche 17 bis 20, wobei die Speisungseinheit (312) eine Ausrichtungseinheit (322) enthält, die angepasst ist, das Versatzkompensationssignal (320) relativ zum vorläufigen Funkfrequenzsignal (318) gemäß einer Ausrichtungseinstellung (328) auszurichten, die Vorrichtung (300; 1000; 1100) des Weiteren umfassend:

- eine Erzeugungseinheit (1302), die angepasst ist zum Erzeugen eines Kalibrierungssignals, das das Versatzsignal (314) ersetzt und von dem das Versatzkompensationssignal (320) gemäß der Ausrichtungseinstellung (328) abgeleitet ist;
- eine Erfassungseinheit (1304), die angepasst ist zum Erfassen einer Komponente, im Funkfrequenzsignal (302), die dem Kalibrierungssignal entspricht; und
- eine Kalibrierungseinheit (1306), die angepasst ist zum Kalibrieren der Ausrichtungseinstellung, wobei die Kalibrierung darauf abzielt, die erfasste Komponente zu reduzieren.

## Revendications

**1.** Procédé (400) de génération d'un signal de radiofréquences (302) sur la base d'un signal de bande de base (304), le procédé comprenant :

- la modification (410) du signal de bande de base (304) par l'ajout d'un signal de décalage (314) au signal de bande de base (304), le signal de décalage (314) étant configuré pour empêcher que le signal de bande de base modifié (316) n'entre dans une première région de signal (502) ;
- la fourniture (420) d'un signal d'amplitude (r ; Vamp ; Vddm) et d'un signal de phase ($\varphi$ ; [Ip,Qp]) sur la base du signal de bande de base modifié (316) ;
- la modulation (430) du signal de phase ($\varphi$ ; [Ip,Qp]) à une fréquence de porteuse ($\omega_c$) et l'amplification du signal de phase modulé en fonction du signal d'amplitude (r ; Vamp ; Vddm) pour générer un signal de radiofréquences préliminaire (318) ; et
- l'alimentation (440) d'un signal de compensation de décalage (320) dérivé du signal de décalage (314) dans le signal de radiofréquences préliminaire (318) pour générer le signal de radiofréquences (302), dans lequel le signal de compensation de décalage (320) est configuré pour annuler au moins sensiblement une composante de distorsion, qui correspond au signal de décalage (314), dans le signal de radiofréquences préliminaire (318).

**2.** Procédé selon la revendication 1, dans lequel l'étape de la modification (410) est effectuée et le signal de compensation de décalage est dérivé du signal de décalage (314), si le signal de bande de base (304) se trouve dans une deuxième région de signal (504), dans lequel une amplitude minimale (R) définit une limite supérieure de la première région de signal (502) et une amplitude d'activation ($r_{min}$) définit une limite supérieure de la deuxième région de signal (504).

**3.** Procédé selon la revendication 1 ou 2, dans lequel au moins l'une de la première région de signal (502) et de la deuxième région de signal (504) change en fonction d'un niveau de signal de sortie du signal de radiofréquences (302) et/ou d'un schéma de modulation appliqué au signal de bande de base (304).

**4.** Procédé selon l'une quelconque des revendications 1 à 3, dans lequel au moins l'une de la modulation et de l'amplification est effectuée en actionnant une composante (310 ; 310-3) dans un mode non linéaire ou dans un mode commuté.

**5.** Procédé selon la revendication 4, dans lequel le signal d'amplitude (r ; Vamp ; Vddm) dépend du signal de bande de base (304) de sorte que le signal de radiofréquences (302) soit au moins sensiblement une translation de fréquence linéaire du signal de bande de base (304).

**6.** Procédé selon l'une quelconque des revendications 1 à 5, dans lequel sensiblement aucun signal de décalage (314) n'est ajouté, si le signal de bande de base (304) se trouve dans une troisième région de signal (802).

**7.** Procédé selon l'une quelconque des revendications 1 à 6, comprenant en outre :

- l'alimentation d'un signal de compensation de pointe (321) dérivé du signal de bande de base (304) dans le signal de radiofréquences préliminaire (318), dans lequel le signal de compensation de pointe (321) compense au moins sensiblement une saturation de l'amplification, si le signal de bande de base (304) se trouve dans une quatrième région de signal (804) ou dans une cinquième région de signal (806).

**8.** Procédé selon la revendication 7, dans lequel l'alimentation du signal de compensation de pointe (321) dans le signal de radiofréquences préliminaire (318) comprend en outre une combinaison pondérée du signal de compensation de pointe (321) et du signal de radiofréquences préliminaire (318).

**9.** Procédé selon la revendication 8, comprenant en outre

- l'étalonnage statique ou dynamique d'un ou plusieurs coefficients de pondération de la combinaison pondérée.

**10.** Procédé selon l'une quelconque des revendications 7 à 9, dans lequel une amplitude de saturation ($r_s$) est au moins l'une d'une limite supérieure de la troisième région de signal (802) et d'une limite inférieure de la quatrième région de signal (804).

**11.** Procédé selon l'une quelconque des revendications 7 à 10, dans lequel le signal de compensation de pointe (321) augmente en fonction du signal de bande de base (304), si le signal de bande de base (304) se trouve dans la cinquième région de signal (806).

**12.** Procédé selon l'une quelconque des revendications 7 à 11, dans lequel une amplitude d'écrêtage ($r_{max}$) définit une limite inférieure de la cinquième région de signal (806).

**13.** Procédé selon l'une quelconque des revendications 7 à 12, dans lequel le signal de compensation de pointe (321) est en outre configuré pour modifier le signal de radiofréquences préliminaire (318) de sorte qu'une approche de la limite inférieure de la cinquième région de signal (806) ait un temps de transition prédéfini.

**14.** Procédé selon l'une quelconque des revendications 7 à 12, dans lequel le signal de compensation de décalage (320) et le signal de compensation de pointe (321) sont générés par un amplificateur de puissance auxiliaire (324 ; 324-3) et le signal de phase ($\varphi$ ; [Ip,Qp]) est appliqué à l'amplificateur de puissance auxiliaire (324 ; 324-3) dans au moins l'une de la quatrième région de signal (804) et de la cinquième région de signal (806).

**15.** Procédé selon la revendication 14, dans lequel l'amplificateur de puissance auxiliaire (324 ; 324-3) peut être un amplificateur de puissance auxiliaire à modulation polaire (324-3) ou un amplificateur de puissance auxiliaire à modulation en quadrature (324).

**16.** Procédé selon l'une quelconque des revendications 1 à 15, dans lequel la dérivation du signal de compensation de décalage (320) comprend l'alignement du signal de compensation de décalage (320) par rapport au signal de radiofréquences préliminaire (318) en fonction d'un réglage d'alignement (328), le procédé (400) comprenant en outre :

- la génération d'un signal d'étalonnage, qui se substitue au signal de décalage (314) et duquel le signal de compensation de décalage (320) est dérivé en fonction du réglage d'alignement (328) ;
- la détection d'une composante, qui correspond au signal d'étalonnage, dans le signal de radiofréquences (302) ; et
- l'étalonnage du réglage d'alignement, dans lequel l'étalonnage vise à réduire la composante détectée.

**17.** Dispositif (300 ; 1000 ; 1100) de génération d'un signal de radiofréquences (302) sur la base d'un signal de bande de base (304), le dispositif comprenant :

- une unité de modification (306) apte à effectuer la modification du signal de bande de base (304) par l'ajout d'un signal de décalage (314) au signal de bande de base (304), le signal de décalage (314) étant configuré pour empêcher que le signal de bande de base modifié (316) n'entre dans une première région de signal (502) ;

- une unité de fourniture (308) apte à effectuer la fourniture d'un signal d'amplitude (r ; Vamp ; Vddm) et d'un signal de phase ($\varphi$ ; [Ip,Qp]) sur la base du signal de bande de base modifié (316) ;

- une unité de modulation et amplification (310) apte à effectuer la modulation du signal de phase ($\varphi$ ; [Ip, Qp]) à une fréquence de porteuse ($\omega_c$) et l'amplification du signal de phase modulé en fonction du signal d'amplitude (r ; Vamp ; Vddm) pour générer un signal de radiofréquences préliminaire (318) ; et

- une unité d'alimentation (312) apte à effectuer l'alimentation d'un signal de compensation de décalage (320) dérivé du signal de décalage (314) dans le signal de radiofréquences préliminaire (318) pour générer le signal de radiofréquences (302), dans lequel le signal de compensation de décalage (320) est configuré pour annuler au moins sensiblement une composante de distorsion, qui correspond au signal de décalage (314), dans le signal de radiofréquences préliminaire (318).

18. Dispositif selon la revendication 17, dans lequel l'unité de modification (306) est activée et/ou le signal de compensation de décalage (320) est dérivé du signal de décalage (314), si le signal de bande de base (304) entre dans une deuxième région de signal (504).

19. Dispositif selon la revendication 17 ou 18, dans lequel l'unité d'alimentation (312) est au moins sensiblement désactivée, si le signal de bande de base se trouve dans une troisième région de signal (802).

20. Dispositif selon l'une quelconque des revendications 17 à 19, dans lequel l'unité d'alimentation (312) est en outre apte à effectuer l'alimentation d'un signal de compensation de pointe (321) dérivé du signal de bande de base (304) dans le signal de radiofréquences préliminaire (318), dans lequel le signal de compensation de pointe (321) compense au moins sensiblement une saturation de l'amplification, si le signal de bande de base (304) se trouve dans une quatrième région de signal (804) ou dans une cinquième région de signal (806).

21. Dispositif selon l'une quelconque des revendications 17 à 20, dans lequel l'unité d'alimentation (312) comprend une unité d'alignement (322) apte à effectuer l'alignement du signal de compensation de décalage (320) par rapport au signal de radiofréquences préliminaire (318) en fonction d'un réglage d'alignement (328), le dispositif (300 ; 1000 ; 1100) comprenant en outre :

- une unité de génération (1302) apte à effectuer la génération d'un signal d'étalonnage, qui se substitue au signal de décalage (314) et duquel le signal de compensation de décalage (320) est dérivé en fonction du réglage d'alignement (328) ;

- une unité de détection (1304) apte à effectuer la détection d'une composante, qui correspond au signal d'étalonnage, dans le signal de radiofréquences (302) ; et

- une unité d'étalonnage (1306) apte à effectuer l'étalonnage du réglage d'alignement, dans lequel l'étalonnage vise à réduire la composante détectée.

Fig. 1

Fig. 2

300

304
306
308
r
310
318
326
302

IQ signal

316

Cartesian-to Polar Conversion

φ

Polar Modulated Power Amp (Main)

PA Output

320,321

312

Offset signal

Amplitude & Phase Alignment

Modulation & Auxiliary Amp

314
322
328
324

# Fig. 3

400

```
┌─────────────────────────────────────────────┐
│  Modify a baseband signal by adding an offset signal to │
│  the baseband signal, the offset signal being configured │       ~410
│  to prevent the modified baseband signal from entering  │
│            a first signal region              │
└─────────────────────────────────────────────┘
                      │
                      ▼
┌─────────────────────────────────────────────┐
│  Provide an amplitude signal (r; Vamp; Vddm) and a │
│    phase signal (φ; [Ip,Qp]) based on the modified │            ~420
│             baseband signal               │
└─────────────────────────────────────────────┘
                      │
                      ▼
┌─────────────────────────────────────────────┐
│   Modulate the phase signal (φ; [Ip,Qp]) to a carrier │
│  frequency (ωc) and amplify the modulated phase signal │
│   according to the amplitude signal (r; Vamp; Vddm) to │        ~430
│        generate a preliminary radio frequency signal │
└─────────────────────────────────────────────┘
                      │
                      ▼
┌─────────────────────────────────────────────┐
│   Feed an offset compensation signal derived from the │
│  offset signal into the preliminary radio frequency signal │
│      to generate the radio frequency signal, wherein the │
│    offset compensation signal is configured to at least │        ~440
│     essentially cancel a distortion component, which │
│  corresponds to the offset signal, in the preliminary radio │
│             frequency signal               │
└─────────────────────────────────────────────┘
```

# Fig. 4

Fig. 5

Fig. 6

Fig. 7

Fig. 8

Fig. 9

Fig. 10

Fig. 11

324-3 ↘                                               outp

$D_{(1)}$    $D_{(2)}$                            $D_{(n-1)}$    $D_{(n)}$

$\cos(\omega_c t + \beta)$

## Fig. 12a

324-3 ↘                                               outn

$D_{(1)}$    $D_{(2)}$                            $D_{(n-1)}$    $D_{(n)}$

$\cos(\omega_c t + \beta + 180°)$

## Fig. 12b

Fig. 13

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1492228 A1
- US 20020122467 A1
- US 20100067617 A1
- US 20080002788 A1
- US 20110116535 A1

**Non-patent literature cited in the description**

- **J. ZHUANG et al.** A Technique to Reduce Phase/Frequency Modulation Bandwidth in a Polar RF Transmitter. *IEEE Trans. on Circuits and Systems I,* vol. 57 (8), 2196-2207